(19) Europäisches Patentamt
European Patent Office
Office européen des brevets

(11) **EP 4 510 814 A1**

(12) **EUROPEAN PATENT APPLICATION**

(43) Date of publication:
**19.02.2025 Bulletin 2025/08**

(21) Application number: **24194728.2**

(22) Date of filing: **15.08.2024**

(51) International Patent Classification (IPC):
**H10K 77/10** (2023.01)

(52) Cooperative Patent Classification (CPC):
**H10K 77/111;** H10K 59/131

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **18.08.2023 KR 20230108550**

(71) Applicant: **Samsung Display Co., Ltd.
Gyeonggi-do 17113 (KR)**

(72) Inventors:
• **KIM, Seongwon
17113 Giheung-gu, Yongin-si (KR)**
• **SONG, Junkyul
17113 Giheung-gu, Yongin-si (KR)**
• **YOON, Jangyeol
17113 Giheung-gu, Yongin-si (KR)**
• **LEE, Gyujeong
17113 Giheung-gu, Yongin-si (KR)**

(74) Representative: **Dr. Weitzel & Partner
Patent- und Rechtsanwälte mbB
Friedenstrasse 10
89522 Heidenheim (DE)**

(54) **DISPLAY DEVICE**

(57)  A display device (1) including a display area (DA), a non-display area (NDA) outside the display area (DA) includes first island portions (11) arranged in the display area (DA), the first island portions (11) being spaced apart from each other in row (X) and column (Y) directions, first bridge portions (12) connecting each of adjacent first island portions (11) among the first island portions (11), second island portions (21) arranged in the non-display area (NDA), the second island portions (21) being spaced apart from each other, and second bridge portions (22) connecting each of adjacent second island portions (21) among the second island portions (21). A first width (Wi1) of each of the first island portions (11) is less than a second width (Wi2) of each of the second island portions (21), and one of the second island portions (21) correspond to a first island portion (11) in an (i)th row and a first island portion (11) in an (i+1)th row. Here, i is a positive integer.

FIG. 4C

**Description**

BACKGROUND

1. Field

The present invention relates to a display device such as a flexible display device.

2. Description of the Related Art

Along with a development of display devices that visually displays various electrical signals, various display devices having excellent characteristics such as thinness, light weight, low power consumption, and the like are being introduced. As an example, flexible display devices that are foldable or rollable in a roll shape are being developed. Recently, research and development on display devices of various structures such as stretchable display devices that may change into various shapes are being actively carried out.

SUMMARY

The invention relates to a display device such as a flexible display device. The invention is defined by the features of the independent claims. The dependent claims describe preferred embodiments.

Additional features will be set forth in part in the description which follows and, in part, will be apparent from the description, or may be learned by practice of the presented embodiments of the invention.

In an embodiment of the present invention, a display device including a display area and a non-display area outside the display area includes first island portions arranged in the display area, the first island portions being spaced apart from each other in row and column directions, first bridge portions respectively connecting two adjacent first island portions among the first island portions, second island portions arranged in the non-display area, the second island portions being spaced apart from each other, and second bridge portions respectively connecting two adjacent second island portions among the second island portions, wherein a first width of each of the first island portions is less than a second width of each of the second island portions, and one of the second island portions corresponds to a first island portion in an (i)th row among the first island portions and a first island portion in an (i+1)th row among the first island portions, where i is a positive integer. In other words, the number of first island portions in a or each row is the double of the number of second island portions in the same row. According to further embodiments, the number of first island portions in a or each row is a multiple of the number of second island portions in the same row.

In an embodiment of the present invention, a display device including a display area and a non-display area outside the display area includes first island portions arranged in the display area, the first island portions being spaced apart from each other in row and column directions, first bridge portions respectively connecting two adjacent first island portions among the first island portions, second island portions arranged in the non-display area, the second island portions being spaced apart from each other, and second bridge portions respectively connecting two adjacent second island portions among the second island portions, wherein a shape of each of the second bridge portions is different from a shape of each of the first bridge portions.

In an embodiment, the one of the second island portions may be connected to the first island portion in the (i)th row and the first island portion in the (i+1)th row through third bridge portions.

In an embodiment, an elongation of the non-display area may be less than an elongation of the display area. The non-display area may include a first sub-non-display area in which the second island portions and the second bridge portions are arranged, and a second sub-non-display area disposed between the first sub-non-display area and the display area, wherein the third bridge portions are arranged in the second sub-non-display area, and an elongation of the first sub-non-display area may be different from an elongation of the second sub-non-display area.

In an embodiment, the elongation of the second sub-non-display area may be less than the elongation of the first sub-non-display area and an elongation of the display area.

In an embodiment, the elongation of the second sub-non-display area may be greater than the elongation of the first sub-non-display area and less than an elongation of the display area.

In an embodiment, each of the first bridge portions may be arranged between two adjacent first island portions immediately next to each other among the first island portions, each of the second bridge portions may be arranged between two adjacent second island portions immediately next to each other among the second island portions, and a first distance between the two adjacent first island portions may be less than a second distance between the two adjacent second island portions immediately next to each other.

In an embodiment, a ratio of the first distance to the first width of each of the first island portion may be greater than a ratio of the second distance to the second width of each of the second island portions.

In an embodiment, a width of each of the first bridge portions may be less than a width of each of the second bridge portions.

In an embodiment, each of the first bridge portions and the second bridge portions may have a serpentine shape.

In an embodiment, each of the first bridge portions may include two first rounded portions, and a straight portion between the two first rounded portions.

In an embodiment, the straight portion of each of the first bridge portions may be oblique with respect to one side of an adjacent first island portion among the first island portions which is immediately next to the straight portion.

In an embodiment, each of the two first rounded portions may have a circular arc shape with a first central angle, and the first central angle may be a reflex angle.

In an embodiment, each of the first bridge portions may further include two second rounded portions respectively connected to the two first rounded portions.

In an embodiment, each of the two second rounded portions may have a circular arc shape with a second central angle, and the second central angle may be less than the first central angle.

In an embodiment, each of the two first rounded portions of each of the first bridge portions may include an inner edge and an outer edge, and the inner edge may have irregularities.

In an embodiment, each of the second bridge portions may have a shape different from a shape of each of the first bridge portions.

In an embodiment, each of the second bridge portions may include two first rounded portions, a first straight portion between the two first rounded portions, two second straight portions respectively connected to the two first rounded portions, and two second rounded portions respectively connected to the two second straight portions.

In an embodiment, a length of the first straight portion of each of the second bridge portions may be greater than a length of each of the two second straight portions.

In an embodiment, each of the two first rounded portions of each of the second bridge portions may have a circular arc shape with a first central angle, and each of the two second rounded portions of each of the second bridge portions may have a circular arc shape with a second central angle, wherein the first central angle may be greater than the second central angle.

In an embodiment, each of the first island portions may include an inorganic insulating layer including an inorganic insulating material, and an edge of the inorganic insulating layer may be spaced apart from an edge of each of the first island portions.

In an embodiment, the display device may further include a substrate under the inorganic insulating layer, wherein the substrate may include a base layer and a barrier layer, the base layer may include polymer resin, and the barrier layer may be disposed on the base layer and may include an inorganic insulating material, and an edge of the barrier layer may be spaced apart from the edge of each of the first island portions.

In an embodiment, the inorganic insulating layer and the barrier layer of the substrate may form a step difference.

In an embodiment, the display device may further include an organic material layer covering the edge of the barrier layer and the edge of the inorganic insulating layer and overlapping the step difference.

In an embodiment, each of the first island portions may include a transistor, and a light-emitting diode electrically connected to the transistor, wherein a portion of a wiring electrically connected to the transistor of one of the first island portions may be disposed on a first bridge portion connected to the one of the first island portions among the first bridge portions, and a first separation distance between an inner edge of the first bridge portion and the wiring may be greater than a second separation distance between an outer edge of the first bridge portion and the wiring.

BRIEF DESCRIPTION OF THE DRAWINGS

The above and other features and advantages of illustrative embodiments of the invention will be more apparent from the following description taken in conjunction with the accompanying drawings, in which:

FIG. 1 is a perspective view of an embodiment of a display device;
FIGS. 2A and 2B are perspective views showing a state in which the display device of FIG. 1 is stretched in a first direction, respectively;
FIG. 2C is a perspective view showing a state in which the display device of FIG. 1 is stretched in a second direction;
FIG. 2D is a perspective view showing a state in which the display device of FIG. 1 is stretched in the first direction and the second direction;
FIG. 2E is a perspective view showing a state in which the display device of FIG. 1 is stretched in a third direction;
FIG. 3 is a schematic plan view of an embodiment of a display device;
FIG. 4A is an enlarged plan view of an embodiment of a region IV of FIG. 3 as a portion of the display device;
FIG. 4B is an enlarged plan view of an embodiment of the region IV of FIG. 3 as a portion of the display device;
FIG. 4C is an enlarged plan view of an embodiment of the region IV of FIG. 3 as a portion of the display device;

FIG. 5 is a schematic cross-sectional view of an embodiment of a first island portion and a first bridge portion arranged in a display area of a display device;

FIGS. 6A to 6C are equivalent circuit diagrams of embodiments of a sub-pixel of a display device , respectively;

FIGS. 7A and 7B are schematic cross-sectional views of embodiments of a light-emitting element of a display device, respectively;

FIG. 8 is a schematic plan view of an embodiment of a portion of a display device;

FIG. 9 is an extracted plan view of a first bridge portion included in a display area of FIG. 8;

FIG. 10 is an extracted plan view of a portion disposed in the display area of FIG. 8;

FIG. 11 is an extracted plan view of a second bridge portion disposed in a non-display area of FIG. 8;

FIG. 12 is an extracted plan view of an embodiment of a display area of a display device;

FIG. 13A is an extracted plan view of an embodiment of a display area of a display device;

FIG. 13B is a schematic plan view of an embodiment of a first rounded portion of a first bridge portion of a display device;

FIG. 14 is an enlarged plan view of an embodiment of a first island portion of a display device;

FIG. 15 is a cross-sectional view of the first island portion of FIG. 14, taken along line XV-XV' of FIG. 14;

FIGS. 16A and 16B are plan views of an embodiment of a configuration of a wiring on a first bridge portion of a display device, respectively; and

FIGS. 17A to 17G are perspective views of embodiments of an electronic apparatus including a display device, respectively.

## DETAILED DESCRIPTION

Reference will now be made in detail to embodiments, embodiments of which are illustrated in the accompanying drawings, where like reference numerals refer to like elements throughout. In this regard, the illustrated embodiments may have different forms and should not be construed as being limited to the descriptions set forth herein. Accordingly, the embodiments are merely described below, by referring to the drawing figures, to explain features of the description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the invention allows for various changes and numerous embodiments, illustrative embodiments will be illustrated in the drawings and described in the written description. Effects and features of the invention, and methods for achieving them will be clarified with reference to embodiments described below in detail with reference to the drawings. However, the invention is not limited to the following embodiments and may be embodied in various forms.

Hereinafter, embodiments will be described with reference to the accompanying drawings, where like reference numerals refer to like elements throughout and a repeated description thereof is omitted.

While such terms as "first" and "second" may be used to describe various elements, such elements must not be limited to the above terms. The above terms are used to distinguish one element from another.

The singular forms "a," "an," and "the" as used herein are intended to include the plural forms as well unless the context clearly indicates otherwise.

It will be understood that the terms "comprise," "comprising," "include" and/or "including" as used herein specify the presence of stated features or elements but do not preclude the addition of one or more other features or elements.

It will be further understood that, when a layer, region, or element is referred to as being "on" another layer, region, or element, it can be directly or indirectly on the other layer, region, or element. That is, for example, intervening layers, regions, or elements may be present.

Sizes of elements in the drawings may be exaggerated or reduced for convenience of explanation. As an example, the size and thickness of each element shown in the drawings are arbitrarily represented for convenience of description, and thus, the invention is not necessarily limited thereto.

In the case where an illustrative embodiment may be implemented differently, a specific process order may be performed in the order different from the described order. As an example, two processes successively described may be simultaneously performed substantially and performed in the opposite order.

It will be understood that when a layer, region, or element is referred to as being "connected" to another layer, region, or element, it may be "directly connected" to the other layer, region, or element or may be "indirectly connected" to the other layer, region, or element with another layer, region, or element located therebetween. For example, it will be understood that when a layer, region, or element is referred to as being "electrically connected" to another layer, region, or element, it may be "directly electrically connected" to the other layer, region, or element or may be "indirectly electrically connected" to the other layer, region, or element with another layer, region, or element interposed therebetween.

The x-axis, the y-axis and the z-axis are not limited to three axes of the rectangular coordinate system, and may be interpreted in a broader sense. For example, the x-axis, the y-axis, and the z-axis may be perpendicular to one another, or may represent different orientations that are not perpendicular to one another.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term "about" can mean within one or more standard deviations, or within $\pm$ 30%, 20%, 10%, 5% of the stated value, for example.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present invention, and will not be interpreted in an idealized or overly formal sense unless expressly so defined herein.

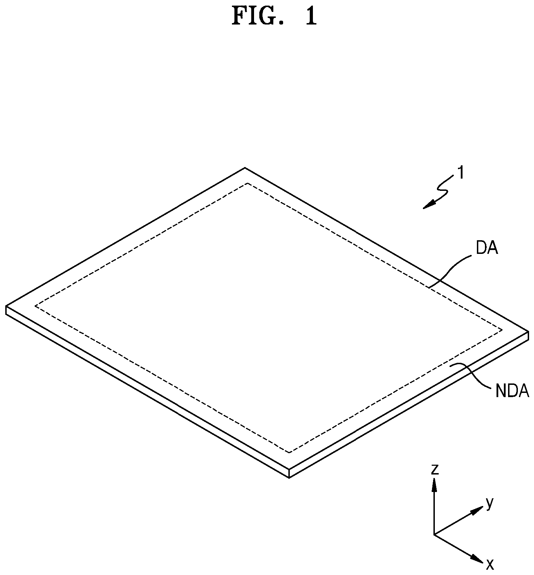

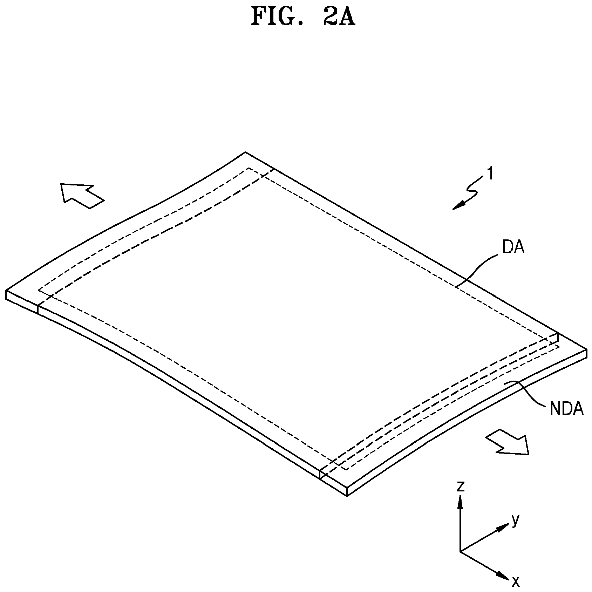

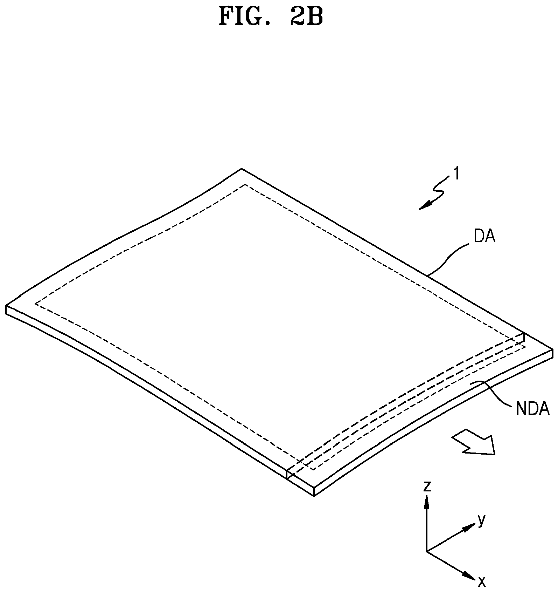

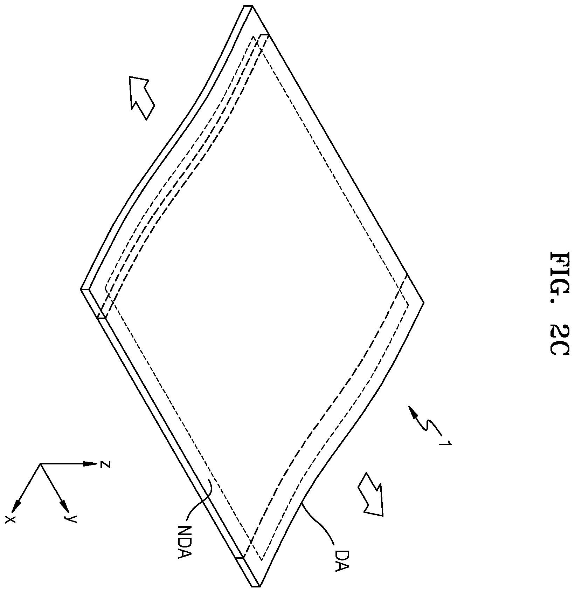

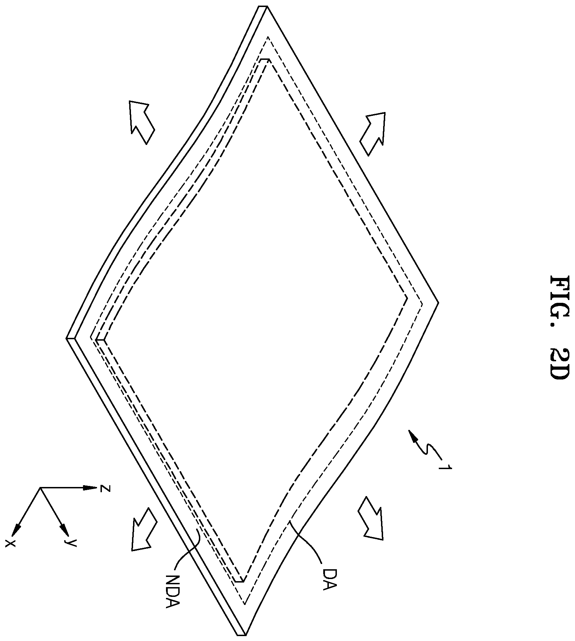

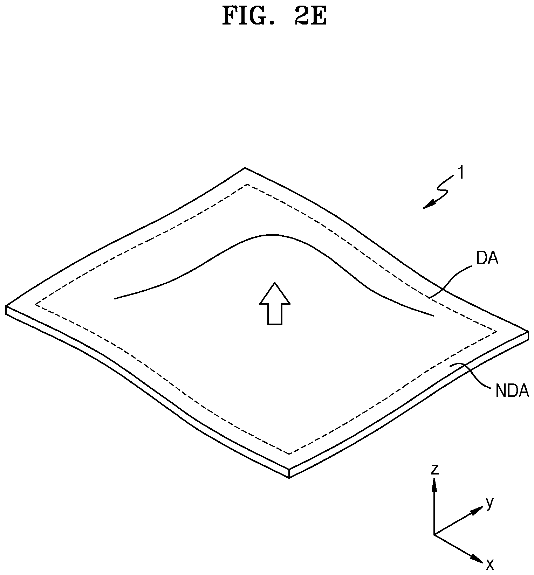

FIG. 1 is a perspective view showing an embodiment of a display device 1. FIGS. 2A and 2B are perspective views of a state in which the display device 1 of FIG. 1 is stretched in a first direction, respectively. FIG. 2C is a perspective view showing a state in which the display device 1 of FIG. 1 is stretched in a second direction. FIG. 2D is a perspective view showing a state in which the display device 1 of FIG. 1 is stretched in the first direction and the second direction. FIG. 2E is a perspective view showing a state in which the display device 1 of FIG. 1 is stretched in a third direction.

Referring to FIG. 1, the display device 1 may include a display area DA and a non-display area NDA. The display area DA may include a plurality of pixels. The display device 1 may display preset images by light emitted from the plurality of pixels. The non-display area NDA may be disposed outside the display area DA. The non-display area NDA is a region in which the pixels are not arranged and may surround an entirety of the display area DA.

The display device 1 may be stretched or shrunk in various directions. The display device 1 may be stretched in a first direction (e.g., an x direction and/or a -x direction) by an external force exerted by an external object or a user. In an embodiment, as shown in FIGS. 2A and 2B, the display area DA and/or the non-display area NDA of the display device 1 may be stretched in the first direction (e.g., the x direction and/or the -x direction). In an embodiment, as shown in FIG. 2A, the display area DA and/or the non-display area NDA may be stretched in the x direction and the -x direction), or be stretched in the x direction with one side of the display device 1 fixed as shown in FIG. 2B.

The display device 1 may be stretched in a second direction (e.g., a y direction and/or a -y direction) due to external force exerted by an external object or a user. In an embodiment, as shown in FIG. 2C, the display area DA and/or the non-display area NDA of the display device 1 may be stretched in the y direction and the -y direction. In another embodiment, the display area DA and/or the non-display area NDA may be stretched in the y direction or the -y direction with one side of the display device 1 fixed.

The display device 1 may be stretched in the first direction (e.g., the x direction and/or the -x direction) and the second direction (e.g., the y direction and/or the -y direction) due to external force exerted by an external object or a portion of a human body, for example. As shown in FIG. 2D, the display area DA and/or the non-display area NDA of the display device 1 may be stretched in a $\pm$x direction and a $\pm$y direction.

The display device 1 may be stretched in a third direction (e.g., a z direction and/or a -z direction) due to external force exerted by an external object or a portion of a human body. In an embodiment, it is shown in FIG. 2E that a portion of the display device 1, e.g., a partial region of the display area DA protrudes in the z direction. In another embodiment, a portion of the display device 1, e.g., a partial region of the display area DA may protrude in a -z direction (or may be depressed in the z direction).

Although it is shown in FIGS. 2A to 2E that the display device 1 is stretched in the first direction, the second direction, and/or the third direction, the invention is not limited thereto. In another embodiment, the display device 1 may be transformed into various shapes such as being bent or twisted along two or more axes.

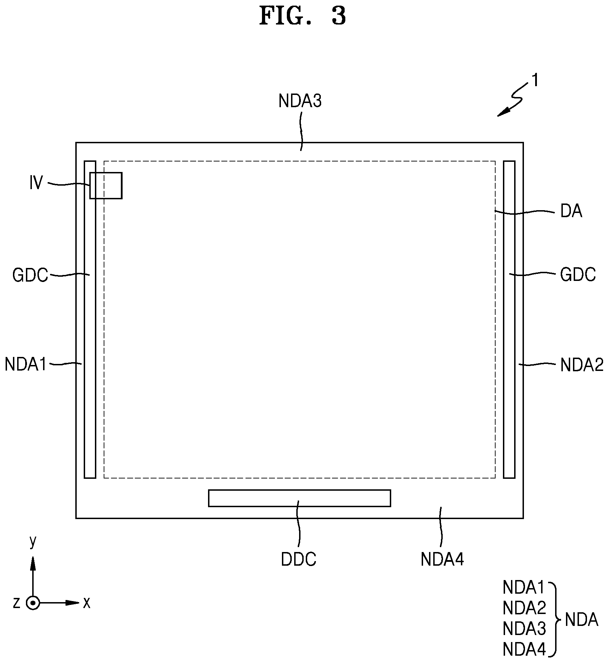

FIG. 3 is a schematic plan view of an embodiment of the display device 1.

A plurality of pixels may be arranged in the display area DA of the display device 1. Each pixel may include sub-pixels which emit light of different colors. A light-emitting element corresponding to each sub-pixel may be disposed in the display area DA. A circuit may be disposed in the non-display area NDA around the display area DA. The circuit provides electrical signals to light-emitting elements and transistors electrically connected to the light-emitting elements arranged in the display area DA. Gate driving circuits GDC may be respectively arranged in a first non-display area NDA1 and a second non-display area NDA2 respectively arranged on two opposite sides with the display area DA therebetween. The gate driving circuits GDC may include drivers which provide electrical signals to a gate electrode of each of the transistors electrically connected to the light-emitting elements. Although it is shown in FIG. 3 that the gate driving circuits GDC are respectively arranged in the first non-display area NDA1 and the second non-display area NDA2, the invention is not limited thereto. In another embodiment, the gate driving circuit GDC may be disposed in one of the first non-display area NDA1 and the second non-display area NDA2.

A data driving circuit DDC may be disposed in a third non-display area NDA3 and/or a fourth non-display area NDA4 each extending to the first non-display area NDA1 and the second non-display area NDA2. In an embodiment, it is shown in FIG. 3 that the data driving circuit DDC is disposed in the fourth non-display area NDA4. In another embodiment, data driving circuits DDC may be respectively arranged in the third non-display area NDA3 and the fourth non-display area NDA4.

Although it is shown in FIG. 3 that the data driving circuit DDC is disposed in the fourth non-display area NDA4 of the display device 1, the invention is not limited thereto. In another embodiment, the display device 1 may further include a flexible circuit board (not shown) electrically connected through a terminal portion (not shown) disposed in the fourth non-display area NDA4, and the data driving circuit DDC may be disposed on the flexible circuit board.

In an embodiment, an elongation of the non-display area NDA may be less than or equal to an elongation of the display area DA. In an embodiment, the elongation of the non-display area NDA may be different for each region thereof. In an embodiment, although the first non-display area NDA1, the second non-display area NDA2, and the third non-display area NDA3 may have a substantially same elongation as each other, an elongation of the fourth non-display area NDA4 may be less than the elongation of each of the first non-display area NDA1, the second non-display area NDA2, and the third non-display area NDA3. The "elongation (or strain)" may denote the change in length ($\Delta L/L$) of a display device due to external force without physical damage to the display device (elongation (or strain) = $\Delta L/L$). Here, $\Delta L$ is the change in length of the display device and L represents the initial length of the display device.

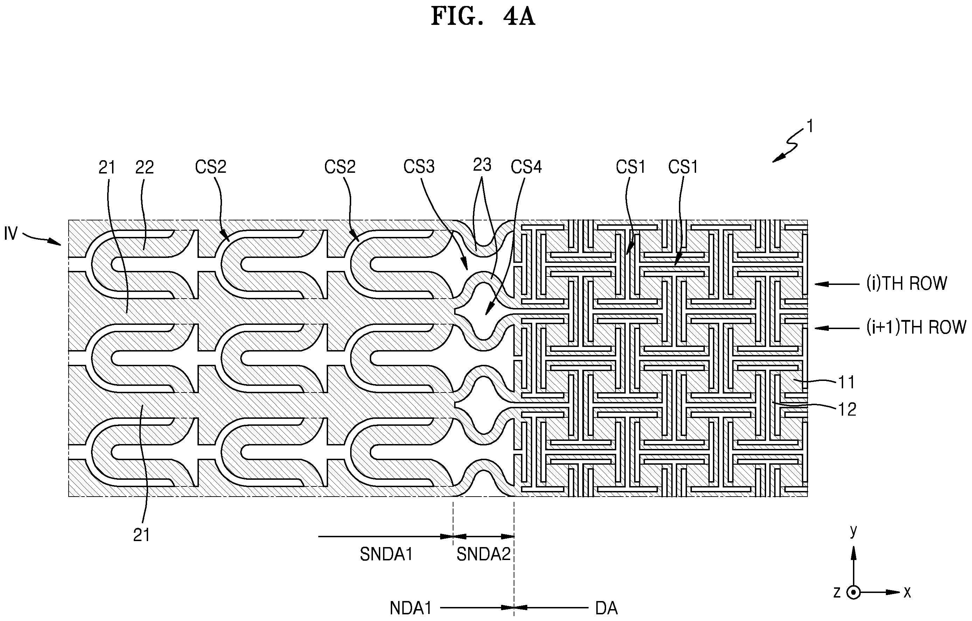

FIG. 4A is an enlarged plan view of an embodiment of a region IV of FIG. 3 as a portion of the display device 1.

Referring to FIG. 4A, the display device 1 may include first island portions 11 and first bridge portions 12 in the display area DA. The first island portions 11 are spaced apart from each other in the first direction (e.g., the x direction or the -x direction) and the second direction (e.g., the y direction or the -y direction), and the first bridge portions 12 connect adjacent first island portions 11. In the disclosure, an expression such as adjacent first island portions 11 may mean that the adjacent first island portions 11 are immediately next to each other.

Each first island portion 11 may be connected to a plurality of first bridge portions 12. In an embodiment, each first island portion 11 may be connected to four first bridge portions 12. Two first bridge portions 12 may be respectively arranged on two opposite sides of the first island portion 11 in the first direction (e.g., the x direction or the -x direction), and the remaining two first bridge portions 12 may be respectively arranged on two opposite sides of the first island portion 11 in the second direction (e.g., the y direction or the -y direction). In an embodiment, four first bridge portions 12 may be respectively connected to four sides of the first island portion 11. The four first bridge portions 12 may be respectively adjacent to the respective corners of the first island portion 11.

The first bridge portions 12 may be spaced apart from each other by a first opening CS1 defined between the first bridge portions 12. In an embodiment, the first openings CS1 having an approximate H shape in the first direction (e.g., the x direction or the -x direction) and the second direction (e.g., the y direction or the -y direction), and the first openings CS1 having an approximate I shape which is rotated by 90° from the H shape may be repeatedly and alternately defined. Two opposite ends of each first bridge portion 12 may be respectively connected to adjacent first island portions 11, and one side of each first bridge portion 12 may be spaced apart from one side of an adjacent first island portion 11 and/or one side of another adjacent first island portion 11 by the first opening CS1.

In the non-display area, e.g., the first non-display area NDA1 shown in FIG. 4A, the display device 1 may include second island portions 21 spaced apart from each other and second bridge portions 22 connecting adjacent second island portions 21.

Each second island portion 21 may extend in the first direction (e.g., the x direction or the -x direction). The second island portions 21 may be spaced apart from each other in the second direction (e.g., the y direction or the -y direction) crossing the first direction (e.g., the x direction or the -x direction). Each second island portion 21 may include drivers of the gate driving circuit GDC described with reference to FIG. 3.

The second bridge portion 22 may have a serpentine shape. The length of the second bridge portion 22 may be greater than a longest distance between adjacent second island portions 21 in the second direction (e.g., the y direction or the -y direction). In an embodiment, the second bridge portion 22 may have an approximate omega ($\Omega$) shape convex in the first direction (e.g., the x direction or the -x direction). The second bridge portions 22 may be arranged between adjacent second island portions 21 and be spaced apart from each other.

The second bridge portions 22 between adjacent second island portions 21 may be spaced apart from each other by a second opening CS2. Between adjacent second island portions 21, the second openings CS2 and the second bridge portions 22 may be alternately arranged in the first direction (e.g., the x direction or the -x direction). The second openings CS2 may have the same shape. Two opposite ends of each second bridge portion 22 may be respectively extended to adjacent second island portions 21, and one side of each second bridge portion 22 may be spaced apart from one side of an adjacent second island portion 21 and/or one side of another adjacent second bridge portion 22 by the second opening CS2.

One second island portion 21 disposed in the first non-display area NDA1 may correspond to the first island portions 11 in a plurality of rows arranged in the display area DA. In an embodiment, one second island portion 21 disposed in the first non-display area NDA1 may correspond to the first island portions 11 in an (i)th row and the first island portions 11 in an (i+1)th row in the display area DA (here, i is an integer greater than 0). Although it is shown in FIG. 4A that one second island portion 21 corresponds to two rows of the first island portions 11, the invention is not limited thereto. In another embodiment, one second island portion 21 disposed in the first non-display area NDA1 may correspond to n rows of the first island portions 11 arranged in the display area DA (here, n is an integer greater than or equal to 3).

The non-display area, e.g., the first non-display area NDA1 may include a first sub-non-display area SNDA1 in which the second island portions 21 and the second bridge portions 22 are arranged, and a second sub-non-display area SNDA2 between the first sub-non-display area SNDA1 and the display area DA. Third bridge portions 23 may be arranged in the second sub-non-display area SNDA2. The third bridge portions 23 connect the display area DA to the first sub-non-display area SNDA1. One end of the third bridge portion 23 may be extended to the second island portion 21 and/or the second bridge portion 22, and an opposite end of the third bridge portion 23 may be connected to the first island portion 11 and/or the first bridge portion 12.

The third bridge portion 23 may have a serpentine shape. In an embodiment, the shape of the third bridge portion 23 may be different from the shape of each of the first bridge portion 12 and the second bridge portion 22. In an embodiment, as shown in FIG. 4A, the third bridge portion 23 may have an approximate omega ($\Omega$) shape convex in the second direction (e.g., the y direction or the -y direction). The third bridge portions 23 may have a structure that is symmetrical to each other, such that one of the adjacent third bridge portions 23 arranged in the second direction (e.g., y-direction or -y-direction) is convex in the y-direction and the other of the adjacent third bridge portions 23 is convex in the -y-direction. A structure in which third openings CS3 and fourth openings CS4 of different shapes are repeated may be provided between the third bridge portions 23. The width of the third bridge portion 23 may be different from the width of the first bridge portion 12 and the width of the second bridge portion 22. In an embodiment, the width of the third bridge portion 23 may be greater than the width of the first bridge portion 12 and less than the width of the second bridge portion 22.

It is shown in FIG. 4A that the second island portion 21 and the second bridge portion 22 in the non-display area NDA, e.g., the first non-display area NDA1, respectively have shapes different from the shapes of the first island portion 11 and the first bridge portion 12 in the display area DA. In another embodiment, the second island portion 21 and the second bridge portion 22 in the non-display area NDA, e.g., the first non-display area NDA1, may have the same shapes as the first island portion 11 and the first bridge portion 12 in the display area DA.

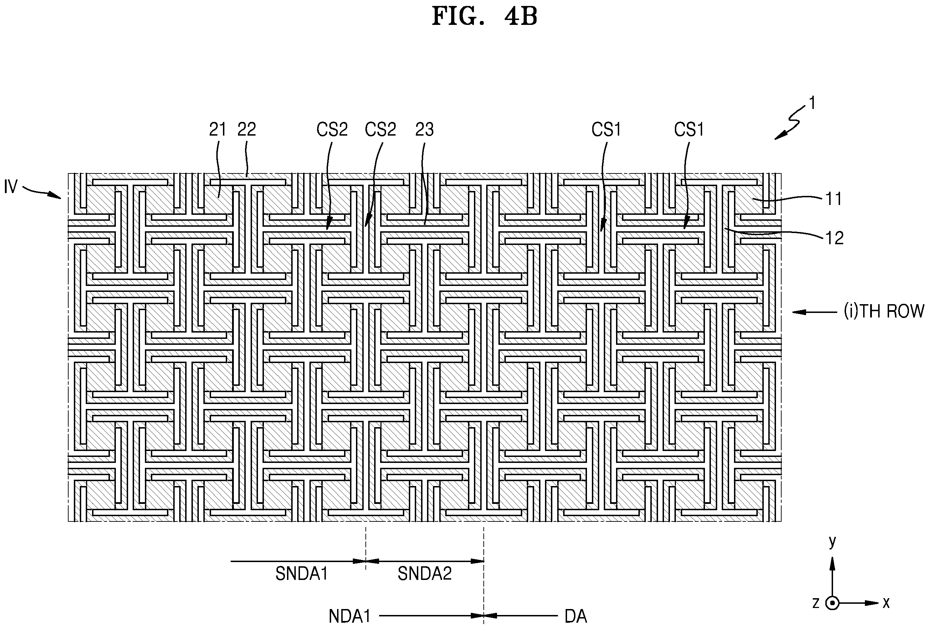

FIG. 4B is an enlarged plan view of an embodiment of a region IV of FIG. 3 as a portion of the display device 1.

Referring to FIG. 4B, the display device 1 includes the first island portions 11 spaced apart from each other, and the first bridge portions 12 in the display area DA. The first bridge portions 12 are spaced apart from each other by the first opening CS1 and connects adjacent first island portions 11. The structure of the display area DA in FIG. 4B may be the same as the structure of the display area DA described above with reference to FIG. 4A.

The display device 1 may include the second island portions 21 and the second bridge portions 22 arranged in the non-display area, e.g., the first non-display area NDA1. In an embodiment, the second island portions 21 and the second bridge portions 22 may respectively have the substantially same shapes as the first island portions 11 and the first bridge portions 12.

The second island portions 21 may be spaced apart from each other in the first direction (e.g., the x direction or the -x direction) and the second direction (e.g., y-direction or -y-direction) in the non-display area, e.g., the first non-display area NDA1. Each of the second bridge portions 22 may connect adjacent second island portions 21. The second bridge portions 22 may be spaced apart from each other by the second opening CS2 defined between the second bridge portions 22.

The second opening CS2 may have the substantially same shape as that of the first opening CS1. In an embodiment, the second opening CS2 having an approximate H shape and the second opening CS2 having an approximate I shape may be alternately and repeatedly defined in the non-display area, e.g., the first non-display area NDA1. Two opposite ends of each second bridge portion 22 may be respectively connected to adjacent second island portions 21, and one side of each second bridge portion 22 may be spaced apart from one side of an adjacent second island portion 21 and/or one side of another adjacent second bridge portion 22 by the second opening CS2.

Each second island portion 21 may be extended to four second bridge portions 22. Each second island portion 21 may include drivers of the gate driving circuit GDC described with reference to FIG. 3.

The second island portions 21 arranged in one row in the first non-display area NDA1 may correspond to the first island portions 11 arranged in one row in the display area DA. In an embodiment, the second island portions 21 arranged in the (i)th row in the first direction (e.g., the x direction or the -x direction) in the first non-display area NDA1 may correspond to the first island portions 11 arranged in the same row, e.g., an (i)th row in the display area DA (here, i is an integer greater than 0).

The display device 1 may include the third bridge portions 23 arranged in the second sub-non-display area SNDA2. The third bridge portions 23 connect the display area DA to the first sub-non-display area SNDA1. The non-display area, e.g., the first non-display area NDA1 may include the first sub-non-display area SNDA1 in which the second island portions 21 and the second bridge portions 22 are arranged, and the second sub-non-display area SNDA2 including the third bridge portions 23 and disposed between the first sub-non-display area SNDA1 and the display area DA. The shape of the third bridge portion 23 may be substantially same as the shapes of the first bridge portion 12 and the second bridge portion 22. In an embodiment, the width of the third bridge portion 23 may be the same as the width of the first bridge portion 12 and the width of the second bridge portion 22.

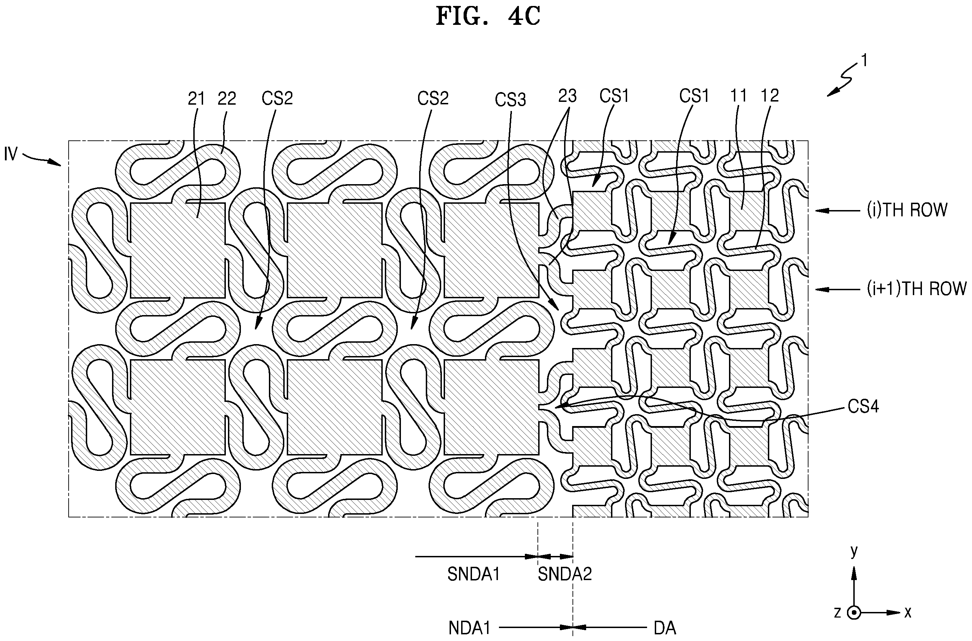

FIG. 4C is an enlarged plan view of an embodiment of the region IV of FIG. 3 as a portion of the display device 1.

Referring to FIG. 4C, the display device 1 may include first island portions 11 and first bridge portions 12 in the display area DA. The first island portions 11 are spaced apart from each other in the first direction (e.g., the x direction or the -x direction) and the second direction (e.g., the y direction or the -y direction), and the first bridge portions 12 connect adjacent first island portions 11 in the display area DA.

The first bridge portions 12 may be spaced apart from each other by a first opening CS1 defined between the first bridge portions 12. The first bridge portion 12 may have a serpentine shape. In an embodiment, as shown in FIG. 4C, the first bridge portion 12 may have an approximate shape of 'alphabet S'.

Each first island portion 11 may be extended to a plurality of first bridge portions 12. In an embodiment, each first island portion 11 may be extended to four first bridge portions 12. Two first bridge portions 12 may be respectively arranged on two opposite sides of the first island portion 11 in the first direction (e.g., the x direction or the -x direction), and the remaining two first bridge portions 12 may be respectively arranged on two opposite sides of the first island portion 11 in the second direction (e.g., the y direction or the -y direction). The four first bridge portions 12 may be respectively extended to four sides of the first island portion 11. The four first bridge portions 12 may be respectively adjacent to the respective corners of the first island portion 11.

In the non-display area, e.g., the first non-display area NDA1 shown in FIG. 4C, the display device 1 may include the second island portions 21 and the second bridge portions 22 connecting adjacent second island portions 21. The second island portions 21 are spaced apart from each other in the first direction (e.g., the x direction or the -x direction) and the second direction (e.g., the y direction or the -y direction) in the first non-display area NDA1 shown in FIG. 4C.

The second bridge portions 22 may be spaced apart from each other by the second opening CS2 defined between the second bridge portions 22. The second bridge portion 22 may have a serpentine shape. In an embodiment, as shown in FIG. 4C, the second bridge portion 22 may have an approximate shape of 'alphabet S'. The size and/or width of the second bridge portion 22 may be different from the size and/or width of the first bridge portion 12. In an embodiment, the size and/or width of the second bridge portion 22 may be greater than the size and/or width of the first bridge portion 12. A radius of curvature of a rounded portion of the second bridge portion 22 may be different from a radius of curvature of a rounded portion of the first bridge portion 12. In an embodiment, the radius of curvature of a rounded portion of the second bridge portion 22 may be greater than the radius of curvature of a rounded portion of the first bridge portion 12.

Each second island portion 21 may be extended to a plurality of second bridge portions 22. Each second island portion 21 may be extended to four second bridge portions 22. Two second bridge portions 22 may be respectively arranged on two opposite sides of the second island portion 21 in the first direction (e.g., the x direction or the -x direction), and the remaining two second bridge portions 22 may be respectively arranged on two opposite sides of the second island portion 21 in the second direction (e.g., the y direction or the -y direction). In an embodiment, four second bridge portions 22 may be respectively extended to four sides of the second island portion 21. Each second bridge portion 22 may be extended to the central portion of each side of the second island portion 21.

The second island portions 21 arranged in one row in the first non-display area NDA1 may correspond to the first island portions 11 arranged in a plurality of rows in the display area DA. In an embodiment, the second island portions 21 arranged in one row in the first non-display area NDA1 may correspond to the first island portions 11 in an (i)th row and the first island portions 11 in an (i+1)th row in the display area DA (here, i is an integer greater than 0). In another embodiment, the second island portions 21 arranged in one row may correspond to n rows of the first island portions 11 (here, n is an integer greater than or equal to 3).

The non-display area, e.g., the first non-display area NDA1 may include a first sub-non-display area SNDA1 in which the second island portions 21 and the second bridge portions 22 are arranged, and a second sub-non-display area SNDA2 between the first sub-non-display area SNDA1 and the display area DA. Third bridge portions 23 may be arranged in the second sub-non-display area SNDA2. The third bridge portions 23 connect the display area DA to the first sub-non-display area SNDA1. One end of the third bridge portion 23 may be extended to the second island portion 21, and an opposite end of the third bridge portion 23 may be extended to the first island portion 11. In an embodiment, one end of the third bridge portion 23 may be extended to the central portion of one side of the second island portion 21, and an opposite end of the third bridge portion 23 may be extended to the central portion of one side of the first island portion 11.

The third bridge portion 23 may have a serpentine shape. In an embodiment, the shape of the third bridge portion 23 may be different from the shape of each of the first bridge portion 12 and the second bridge portion 22. The width of the third bridge portion 23 may be different from the width of the first bridge portion 12 and the width of the second bridge portion 22. The width of the third bridge portion 23 may be greater than the width of the first bridge portion 12 and less than the width of the second bridge portion 22. In the second direction (e.g., the y direction or the -y direction), the third openings CS3 and the fourth openings CS4 having different shapes may be alternately defined between the third bridge portions 23.

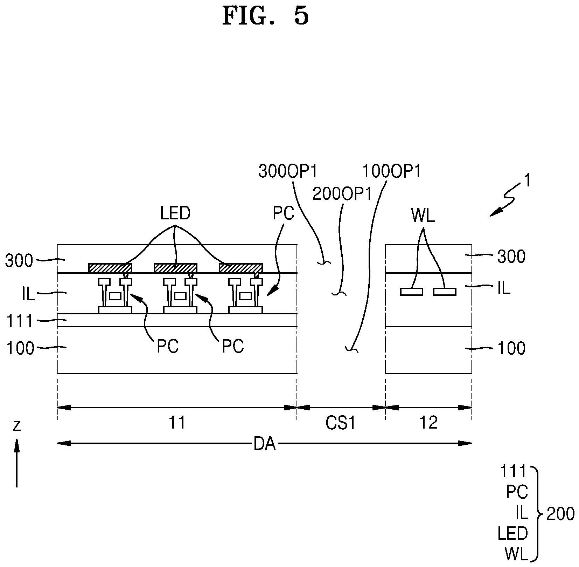

FIG. 5 is a schematic cross-sectional view of an embodiment of the first island portion 11 and the first bridge portion 12 arranged in the display area DA of the display device 1.

Referring to FIG. 5, the first island portion 11 and the first bridge portion 12 arranged in the display area DA may be spaced apart from each other with the first opening CS1 therebetween. The first island portion 11 may include light-emitting elements LED and a circuit, e.g., a pixel driving circuit PC electrically connected to the light-emitting elements LED and driving the light-emitting elements LED. The first bridge portion 12 may include a wiring WL electrically connected to the pixel driving circuits PC respectively arranged on adjacent first island portions 11.

In the first island portion 11, a buffer layer 111 including an inorganic insulating material may be disposed on a substrate 100, and the pixel driving circuit PC may be disposed on the buffer layer 111. An insulating layer IL including an inorganic insulating material and/or an organic insulating material may be disposed between the pixel driving circuit PC and the light-emitting element LED. The light-emitting element LED may be disposed on the insulating layer IL and electrically connected to the pixel driving circuit PC. The light-emitting elements LED may emit light of different colors or emit light of the same color. In an embodiment, the light-emitting elements LED may respectively emit red, green, and blue light. In an embodiment, the light-emitting elements LED may emit white light. In another embodiment, the light-emitting elements LED may respectively emit red, green, blue, and white light.

The substrate 100 may include polymer resin such as polyethersulfone, polyarylate, polyetherimide, polyethylene naphthalate, polyethylene terephthalate, polyphenylene sulfide, polyimide, polycarbonate, cellulose tri acetate, or cellulose acetate propionate. In an embodiment, the substrate 100 may include a single layer including the polymer resin. In another embodiment, the substrate 100 may have a multi-layered structure including a base layer and a barrier layer. The base layer includes the above polymer resin and the barrier layer includes an inorganic insulating material. The substrate 100 including the polymer resin is flexible, rollable, or bendable.

In an embodiment, although it is shown in FIG. 5 that three pixel driving circuits PC (or three portions of the pixel driving circuit PC) are arranged in the first island portion 11, and three light-emitting elements LED are respectively connected to the three pixel driving circuits PC (or three portions of the pixel driving circuit PC), the invention is not limited thereto. In another embodiment, the number of pixel driving circuits PC (or portions of the pixel driving circuit PC) and the number of light-emitting elements LED arranged in the first island portion 11 may be one, two, four, or more.

An encapsulation layer 300 may be disposed on the light-emitting element LED and may protect the light-emitting element LED from external force and/or moisture penetration. The encapsulation layer 300 may include an inorganic encapsulation layer and/or an organic encapsulation layer. In an embodiment, the encapsulation layer 300 may have a structure in which an inorganic encapsulation layer including an inorganic insulating material, an organic encapsulation layer including an organic insulating material, and an inorganic encapsulation layer including an inorganic insulating material are stacked. In another embodiment, the encapsulation layer 300 may include an organic material such as resin. In an embodiment, the encapsulation layer 300 may include urethane, epoxy or acrylate. The encapsulation layer 300 may include a photosensitive material, e.g., a photoresist.

In the first bridge portion 12, the insulating layer IL including an organic insulating material may be disposed on the substrate 100. Unlike the first island portion 11, the first bridge portion 12, which is relatively transformed much when the display device 1 is stretched, may not include a layer including an inorganic insulating material that is prone to cracks.

In an embodiment, the substrate 100 corresponding to the first bridge portion 12 may have the same stack structure as that of the substrate 100 corresponding to the first island portion 11. In an embodiment, the substrate 100 corresponding to the first bridge portion 12 and the substrate 100 corresponding to the first island portion 11 may include polymer resin layers simultaneously formed during the same process, for example. In another embodiment, the substrate 100 corresponding to the first bridge portion 12 may have a stack structure different from that of the substrate 100 corresponding to the first island portion 11. In an embodiment, the substrate 100 corresponding to the first island portion 11 may have a multi-layered structure including a base layer including polymer resin and a barrier layer including an inorganic insulating material, and the substrate 100 corresponding to the first bridge portion 12 may have a structure of a polymer resin layer without a layer including an inorganic insulating material, for example.

As described above, the wirings WL of the first bridge portion 12 may be signal lines (e.g., a gate line, a data line, or the like) which provide electrical signals to transistors included in the pixel driving circuit PC of the first island portion 11, or voltage lines (e.g., a driving voltage line, an initialization voltage line, or the like) which provide voltages. The encapsulation layer 300 may be disposed also on the first bridge portion 12. In another embodiment, the encapsulation layer 300 may not be in the first bridge portion 12.

Referring to FIGS. 4A to 4C, and 5, the substrate 100 corresponding to the first island portion 11 and the substrate 100 corresponding to the first bridge portion 12 may be extended or connected to each other. In other words, the plan views shown above in FIGS. 4A to 4C may be substantially same as the plan view of the substrate 100 of FIG. 5. In other words, the substrate 100 may include a region corresponding to the first island portion 11, and a region corresponding to the first bridge portion 12, and an opening 100OP1 having a shape equal to the shape of the first opening CS1 may be defined in the substrate 100.

Similarly, the encapsulation layer 300 corresponding to the first island portion 11 and the encapsulation layer 300 corresponding to the first bridge portion 12 may be extended to or connected to each other. In an embodiment, the plan views shown above in FIGS. 4A to 4C may be substantially same as the plan view of the encapsulation layer 300 of FIG. 5. In other words, the encapsulation layer 300 may include a region corresponding to the first island portion 11, and a region corresponding to the first bridge portion 12, and an opening 300OP1 having a shape equal to the shape of the first opening CS1 may be defined in the encapsulation layer 300.

A circuit-light-emitting element layer 200 between the substrate 100 and the encapsulation layer 300 may include the buffer layer 111, the pixel driving circuit PC, the wiring WL, the insulating layer IL, and the light-emitting element LED. Similar to the substrate 100, the plan views shown above in FIGS. 4A to 4C may be substantially same as the plan view of the circuit-light-emitting element layer 200 of FIG. 5. In other words, the circuit-light-emitting element layer 200 may define an opening 200OP1 having a shape equal to the shape of the first opening CS1.

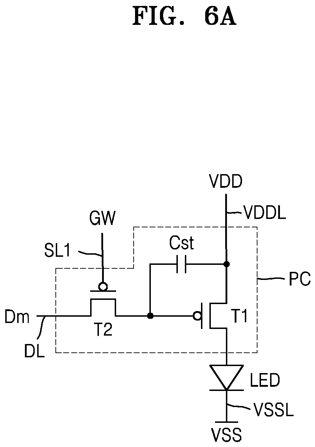

FIGS. 6A to 6C are equivalent circuit diagrams of embodiments of a sub-pixel of the display device, respectively.

Referring to FIG. 6A, the light-emitting element LED corresponding to the sub-pixel may be electrically connected to the pixel driving circuit PC, and the pixel driving circuit PC may include a first transistor T1, a second transistor T2, and a storage capacitor Cst. The pixel driving circuit PC may be electrically connected to the signal lines and the voltage lines. The signal lines may include a gate line such as a first scan line SL1, and a data line DL. The voltage lines may include a first voltage line VDDL.. The light-emitting element LED may be electrically connected to the pixel driving circuit PC and the second voltage line VSSL.

The second transistor T2 may be electrically connected to the first scan line SL1 and the data line DL. The first scan line SL1 may provide a first scan signal GW to a gate electrode of the second transistor T2. The second transistor T2 may transfer a data signal Dm to the first transistor T1 according to a first scan signal GW input from the first scan line SL1. The data signal Dm is input from the data line DL.

The storage capacitor Cst may be electrically connected to the second transistor T2 and a first voltage line VDDL and store a voltage corresponding to a difference between a voltage transferred from the second transistor T2 and a first power voltage VDD supplied by the first voltage line VDDL.

The first transistor T1 serves as a driving transistor and may control a driving current flowing through the light-emitting element LED. The first transistor T1 may be connected to the first voltage line VDDL and the storage capacitor Cst. The first transistor T1 may control the driving current flowing from the first voltage line VDDL to the light-emitting element LED in response to a value of the voltage stored in the storage capacitor Cst. The light-emitting element LED may emit light having a preset brightness based on the driving current. A first electrode of the light-emitting element LED may be electrically connected to the first transistor T1, and a second electrode of the light-emitting element LED may be electrically connected to a second voltage line VSSL which supplies a second power voltage VSS.

Although it is shown in FIG. 6A that the pixel driving circuit PC includes two transistors and one storage capacitor, the pixel driving circuit PC may include three or more transistors, or two or more capacitors.

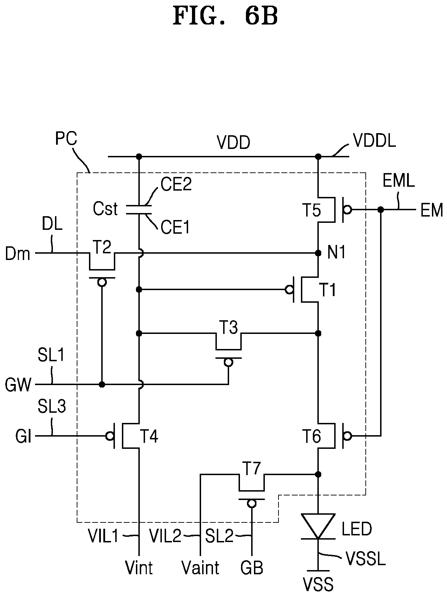

Referring to FIG. 6B, the pixel driving circuit PC may include the first transistor T1, the second transistor T2, a third transistor T3, a fourth transistor T4, a fifth transistor T5, a sixth transistor T6, a seventh transistor T7, and the storage capacitor Cst.

The pixel driving circuit PC is electrically connected to the signal lines and the voltage lines. The signal lines may include gate lines such as the first scan line SL1, a second scan line SL2, a third scan line SL3, a gate line such as an emission control line EML, and the data line DL. The voltage lines may include first and second initialization voltage lines VIL1 and VIL2 and the first voltage line VDDL. The light-emitting element LED may be electrically connected to the pixel driving circuit PC and the second voltage line VSSL.

The first voltage line VDDL may transfer the first power voltage VDD to the first transistor T1. The first initialization voltage line VIL1 may transfer a first initialization voltage Vint to the pixel driving circuit PC. The first initialization voltage Vint initializes the first transistor T1. The second initialization voltage line VIL2 may transfer a second initialization voltage Vaint to the pixel driving circuit PC. The second initialization voltage Vaint initializes a first electrode of the light-emitting element LED.

The first transistor T1 may be electrically connected to the first voltage line VDDL through the fifth transistor T5, and electrically connected to the light-emitting element LED through the sixth transistor T6. The first transistor T1 serves as the driving transistor, receives a data signal Dm, and supplies the driving current to the light-emitting element LED according to a switching operation of the second transistor T2.

The second transistor T2 serves as a data-write transistor and is electrically connected to the first scan line SL1 and the data line DL. The second transistor T2 may be connected to the first voltage line VDDL through the fifth transistor T5. The second transistor T2 is turned on according to a first scan signal GW transferred through the first scan line SL1, and performs a switching operation of transferring a data signal Dm to a first node N1, the data signal Dm being transferred through the data line DL.

The third transistor T3 is electrically connected to the first scan line SL1 and electrically connected to the light-emitting element LED through the sixth transistor T6. The third transistor T3 may be turned on according to a first scan signal GW to diode-connect the first transistor T1. The first scan signal GW is transferred through the first scan line SL1.

The fourth transistor T4 serves as a first initialization transistor and is electrically connected to the first initialization voltage line VIL1. The fourth transistor T4 may be turned on according to a third scan signal GI to initialize a gate voltage of the first transistor T1 by transferring the first initialization voltage Vint to the gate electrode of the first transistor T1. The first initialization voltage Vint is transferred through the first initialization voltage line VIL1, and the third scan signal GI is transferred through the third scan line SL3. A third scan signal GI may correspond to a first scan signal of another pixel driving circuit disposed in a previous row of the relevant pixel driving circuit PC.

The fifth transistor T5 may serve as an operation control transistor, and the sixth transistor T6 may serve as an emission control transistor. The fifth transistor T5 and the sixth transistor T6 may be electrically connected to the emission control line EML, simultaneously turned on according to an emission control signal EM transferred through the emission control line EML, and may define a current path such that the driving current flows in a direction from the first voltage line VDDL to the light-emitting element LED.

The seventh transistor T7 serves as a second initialization transistor and may be electrically connected to the second scan line SL2, the second initialization voltage line VIL2, and the sixth transistor T6. The seventh transistor T7 is turned on according to a second scan signal GB transferred through the second scan line SL2, and transfers the second initialization voltage Vaint from the second initialization voltage line VIL2 to the first electrode of the light-emitting element LED, thereby initializing the first electrode of the light-emitting element LED.

The storage capacitor Cst includes a first electrode CE1 and a second electrode CE2. The first electrode CE1 is electrically connected to the gate electrode of the first transistor T1, and the second electrode CE2 is electrically connected to the first voltage line VDDL. The storage capacitor Cst may maintain a voltage applied to the gate electrode of the first transistor T1 by storing and maintaining a voltage corresponding to a difference between voltages of two opposite ends respectively connected to the gate electrode of the first transistor T1 and the first voltage line VDDL.

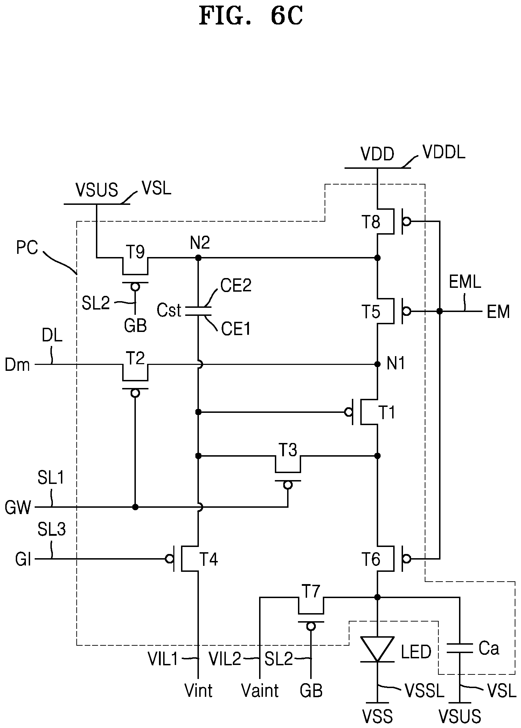

Referring to FIG. 6C, the pixel driving circuit PC may include the first transistor T1, the second transistor T2, the third transistor T3, the fourth transistor T4, the fifth transistor T5, the sixth transistor T6, the seventh transistor T7, an eighth transistor T8, a ninth transistor T9, the storage capacitor Cst and an auxiliary capacitor Ca.

The pixel driving circuit PC is electrically connected to the signal lines and the voltage lines. The signal lines may include the gate lines such as the first scan line SL1, the second scan line SL2, the third scan line SL3, and the emission control line EML, and the data line DL. The voltage lines may include the first and second initialization voltage lines VIL1 and VIL2, a sustain voltage line VSL, and the first voltage line VDDL. The light-emitting element LED may be electrically connected to the pixel driving circuit PC and the second voltage line VSSL.

The first voltage line VDDL may transfer the first power voltage VDD to the first transistor T1. The first initialization voltage line VIL1 may transfer the first initialization voltage Vint to the pixel driving circuit PC. The first initialization voltage Vint initializes the first transistor T1. The second initialization voltage line VIL2 may transfer the second initialization voltage Vaint to the pixel driving circuit PC. The second initialization voltage Vaint initializes the first electrode of the light-emitting element LED. The sustain voltage line VSL may provide a sustain voltage VSUS to a second node N2, e.g., the second electrode CE2 of the storage capacitor Cst during an initialization section and a data-write section.

The first transistor T1 may be electrically connected to the first voltage line VDDL through the fifth transistor T5 and the eighth transistor T8, and electrically connected to the light-emitting element LED through the sixth transistor T6. The first transistor T1 serves as the driving transistor, receives a data signal Dm, and supplies the driving current to the light-emitting element LED according to a switching operation of the second transistor T2.

The second transistor T2 is electrically connected to the first scan line SL1 and the data line DL and electrically connected to the first voltage line VDDL through the fifth transistor T5 and the eighth transistor T8. The second transistor T2 may be turned on according to a first scan signal GW transferred through the first scan line SL1 and may perform a switching operation of transferring a data signal Dm to the first node N1. The data signal Dm is transferred through the data line DL.

The third transistor T3 is electrically connected to the first scan line SL1 and electrically connected to the light-emitting element LED through the sixth transistor T6. The third transistor T3 may be turned on according to a first scan signal GW to compensate for a threshold voltage of the first transistor T1 by diode-connecting the first transistor T1. The first scan signal GW is transferred through the first scan line SL1.

The fourth transistor T4 is electrically connected to the third scan line SL3 and the first initialization voltage line VIL1, turned on according to a third scan signal GI transferred through the third scan line SL3, and initializes the voltage of the gate electrode of the first transistor T1 by transferring the first initialization voltage Vint to the gate electrode of the first transistor T1. The first initialization voltage Vint is transferred through the first initialization voltage line VIL1. A third scan signal GI may correspond to a first scan signal of another pixel driving circuit disposed in a previous row of the relevant pixel driving circuit PC.

The fifth transistor T5, the sixth transistor T6, and the eighth transistor T8 may be electrically connected to the emission control line EML, simultaneously turned on according to an emission control signal EM transferred through the emission control line EML, and may define a current path such that the driving current flows in a direction from the first voltage line VDDL to the light-emitting element LED.

The seventh transistor T7 serves as a second initialization transistor and may be electrically connected to the second scan line SL2, the second initialization voltage line VIL2, and the sixth transistor T6. The seventh transistor T7 is turned on according to a second scan signal GB transferred through the second scan line SL2, and transfers the second initialization voltage Vaint from the second initialization voltage line VIL2 to the first electrode of the light-emitting element LED, thereby initializing the first electrode of the light-emitting element LED.

The ninth transistor T9 may be electrically connected to the second scan line SL2, the second electrode CE2 of the storage capacitor Cst, and the sustain voltage line VSL. The ninth transistor T9 may be turned according to a second scan signal GB transferred through the second scan line SL2 and transfer the sustain voltage VSUS to the second node N2, e.g., the second electrode CE2 of the storage capacitor Cst during the initialization section and the data-write section.

Each of the eighth transistor T8 and the ninth transistor T9 may be electrically connected to the second node N2, e.g., the second electrode CE2 of the storage capacitor Cst. In an embodiment, during the initialization section and the data-write section, the eighth transistor T8 may be turned off and the ninth transistor T9 may be turned on, and during an emission section, the eighth transistor T8 may be turned on and the ninth transistor T9 may be turned off. Because, during the initialization section and the data-write section, the sustain voltage VSUS is transferred to the second node N2, uniformity in brightness (e.g., long range uniformity ("LRU")) of the display device corresponding to a voltage drop of the first voltage line VDDL may be improved.

The storage capacitor Cst includes the first electrode CE1 and the second electrode CE2. The first electrode CE1 is electrically connected to the gate electrode of the first transistor T1, and the second electrode CE2 is electrically connected to the eighth transistor T8 and the ninth transistor T9.

The auxiliary capacitor Ca may be electrically connected to the sixth transistor T6, the sustain voltage line VSL, and the first electrode of the light-emitting element LED. While the seventh transistor T7 and the ninth transistor T9 are turned on, the auxiliary capacitor Ca stores and maintains a voltage corresponding to a difference between the voltage of the first electrode of the light-emitting element LED and the sustain voltage VSUS of the sustain voltage line VSL, thereby preventing a black brightness from rising when the sixth transistor T6 is turned off.

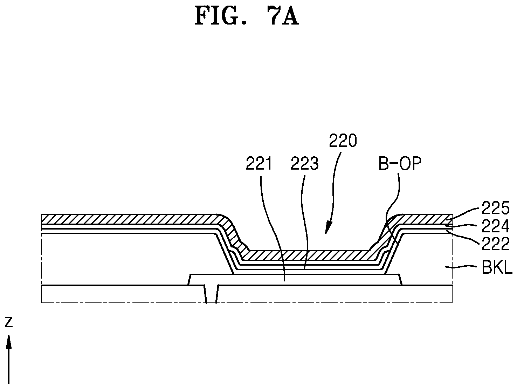

FIG. 7A is a schematic cross-sectional view of an embodiment of the light-emitting element of the display device.

Referring to FIG. 7A, the light-emitting element in an embodiment may include an organic light-emitting diode 220 including an organic material. The organic light-emitting diode 220 may include a first electrode 221 disposed on an insulating layer, a second electrode 225 facing the first electrode 221, and an emission layer 223 disposed between the first electrode 221 and the second electrode 225. A first functional layer 222 may be disposed between the first electrode 221 and the emission layer 223, and a second functional layer 224 may be disposed between the emission layer 223 and the second electrode 225.

The edges of the first electrode 221 may be covered by a bank layer BKL including an insulating material. The bank layer BKL may define an opening B-OP overlapping the central portion of the first electrode 221.

The first electrode 221 may include a conductive oxide such as indium tin oxide ("ITO"), indium zinc oxide ("IZO"), zinc oxide (ZnO), indium oxide (InzOs), indium gallium oxide ("IGO"), and/or aluminum zinc oxide ("AZO"). In another embodiment, the first electrode 221 may include a reflective layer including silver (Ag), magnesium (Mg), aluminum (Al), platinum (Pt), palladium (Pd), gold (Au), nickel (Ni), neodymium (Nd), iridium (Ir), chrome (Cr), or any combinations thereof. In another embodiment, the first electrode 221 may further include a layer on/under the reflective layer, the layer including ITO, IZO, ZnO, AZO, or $In_2O_3$.

The emission layer 223 may include a polymer organic material or a low-molecular weight organic material emitting light having a preset color. The first functional layer 222 may include a hole transport layer ("HTL") and/or a hole injection layer ("HIL"). The second functional layer 224 may include an electron transport layer ("ETL") and/or an electron injection layer ("EIL").

The second electrode 225 may include a conductive material having a relatively low work function. In an embodiment, the second electrode 225 may include a (semi) transparent layer including silver (Ag), magnesium (Mg), aluminum (Al), platinum (Pt), palladium (Pd), gold (Au), nickel (Ni), neodymium (Nd), iridium (Ir), chrome (Cr), or any alloys thereof. In an alternative embodiment, the second electrode 225 may further include a layer on the (semi) transparent layer, the layer including ITO, IZO, ZnO, AZO, or $In_2O_3$.

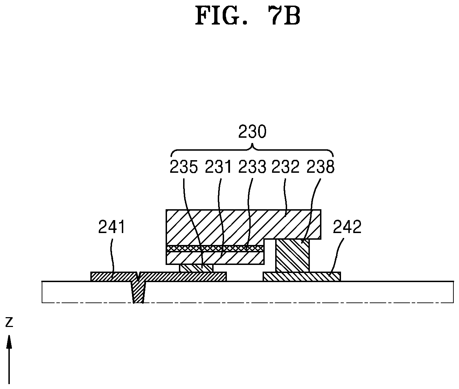

FIG. 7B is a schematic cross-sectional view of an embodiment of the light-emitting element of the display device.

Referring to FIG. 7B, the light-emitting element in an embodiment may include an inorganic light-emitting diode 230 including an inorganic material. The inorganic light-emitting diode 230 may include a first semiconductor layer 231, a second semiconductor layer 232, an intermediate layer 233 between the first semiconductor layer 231 and second semiconductor layer 232, a first electrode 235 electrically connected to the first semiconductor layer 231, and a second electrode 238 electrically connected to the second semiconductor layer 232. The first electrode 235 and the second electrode 238 of the inorganic light-emitting diode 230 may be respectively and electrically connected to a first electrode pad 241 and a second electrode pad 242 disposed in the same layer.

In an embodiment, the first semiconductor layer 231 may include a p-type semiconductor layer. The p-type semiconductor layer may include a semiconductor material with a composition formula of $In_xAl_yGa_{1-x-y}N$ ($0 \leq x \leq 1$, $0 \leq y \leq 1$, $0 \leq x+y \leq 1$), such as GaN, AIN, AlGaN, InGaN, InN, InAlGaN, AllnN, or the like, and may be doped with a p-type dopant such as Mg, Zn, Ca, Sr, Ba, or the like.

In an embodiment, the second semiconductor layer 232 may include an n-type semiconductor layer. The n-type semiconductor layer may include a semiconductor material with a composition formula of $In_xAl_yGa_{1-x-y}N$ ($0 \leq x \leq 1$, $0 \leq y \leq 1$, $0 \leq x+y \leq 1$), such as GaN, AlN, AlGaN, InGaN, InN, InAlGaN, AllnN, or the like, and may be doped with n-type dopants such as Si, Ge, Sn, or the like.

The intermediate layer 233 is a region where electrons and holes recombine. As the electrons and holes recombine in the intermediate layer 233, excitons may be generated, and the generated excitons may transit to a lower energy level and may generate light having a corresponding wavelength. In an embodiment, the intermediate layer 233 may include a semiconductor material with a composition formula of $In_xAl_yGa_{1-x-y}N$ ($0 \leq x \leq 1$, $0 \leq y \leq 1$, $0 \leq x+y \leq 1$), and may be formed in a single quantum well structure or a multi quantum well ("MQW") structure, for example. In addition, the intermediate layer 233 may include a quantum wire structure or a quantum dot structure.

Although it is described in FIG. 7B that the first semiconductor layer 231 includes a p-type semiconductor layer, and the second semiconductor layer 232 includes an n-type semiconductor layer, the invention is not limited thereto. In another embodiment, the first semiconductor layer 231 may include an n-type semiconductor layer, and the second semiconductor layer 232 may include a p-type semiconductor layer.

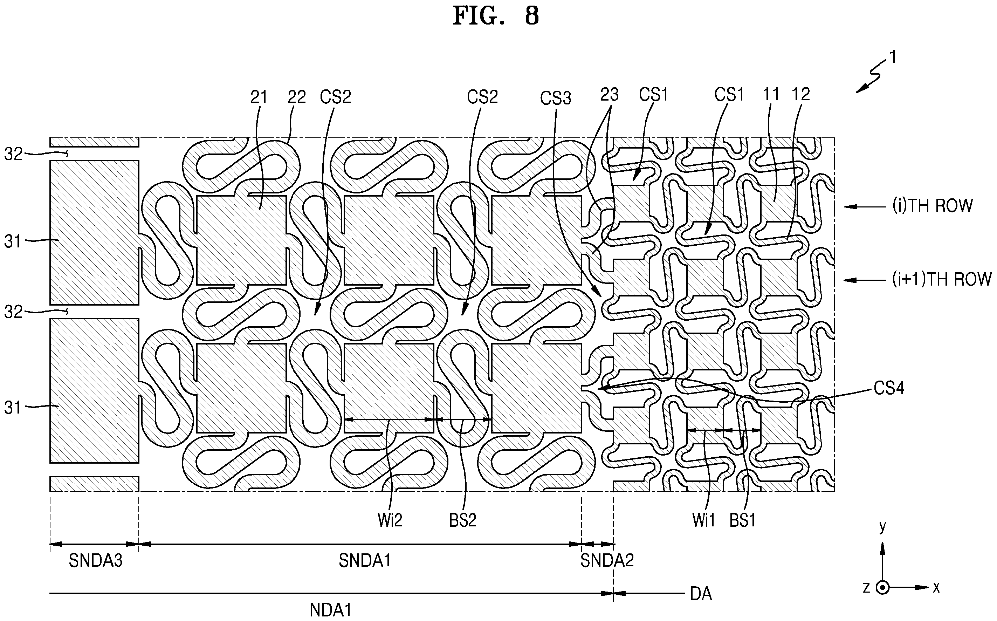

FIG. 8 is a schematic plan view of an embodiment of a portion of the display device 1.

Referring to FIG. 8, the display device 1 may include the first island portions 11 and the first bridge portions 12 in the display area DA. The first island portions 11 are spaced apart from each other in the first direction (e.g., the x direction or the -x direction) and the second direction (e.g., the y direction or the -y direction), and the first bridge portions 12 connect adjacent first island portions 11 in the display area DA. The first bridge portions 12 may be spaced apart from each other by a first opening CS1 defined between the first bridge portions 12. The first bridge portion 12 may have a serpentine shape (e.g., an approximate " alphabet S" shape).

Each first island portion 11 may be extended to a plurality of first bridge portions 12. In an embodiment, each first island portion 11 may be extended to four first bridge portions 12. Two first bridge portions 12 may be respectively arranged on two opposite sides of the first island portion 11 in the first direction (e.g., the x direction or the -x direction), and the remaining two first bridge portions 12 may be respectively arranged on two opposite sides of the first island portion 11 in the second direction (e.g., the y direction or the -y direction). The four first bridge portions 12 may be respectively extended to four sides of the first island portion 11. Each of the first bridge portions 12 may be adjacent to the corner of the first island portion 11.

In the display device 1, the non-display area, e.g., the first non-display area NDA1 shown in FIG. 8 may include the first sub-non-display area SNDA1, the second sub-non-display area SNDA2, and a third sub-non-display area SNDA3. The second sub-non-display area SNDA2 may be disposed between the first sub-non-display area SNDA1 and the display area DA. The third sub-non-display area SNDA3 may be disposed on the opposite side of the second sub-non-display area SNDA2 with the first sub-non-display area SNDA1 therebetween. The third sub-non-display area SNDA3 may correspond to the outermost portion of the display device 1.

The second island portions 21 and the second bridge portions 22 may be arranged in the first sub-non-display area SNDA1. The second island portions 21 are spaced apart from each other in the first direction (e.g., the x direction or the -x direction) and the second direction (e.g., the y direction or the -y direction), and the second bridge portions 22 connect adjacent second island portions 21. The second bridge portions 22 may be spaced apart from each other by the second opening CS2 defined between the second bridge portions 22. The second bridge portion 22 may have a serpentine shape (e.g., an approximate " alphabet S" shape).

Each second island portion 21 may be extended to a plurality of second bridge portions 22. Each second island portion 21 may be extended to four second bridge portions 22. Two second bridge portions 22 may be respectively arranged on two opposite sides of the second island portion 21 in the first direction (e.g., the x direction or the -x direction), and the remaining two second bridge portions 22 may be respectively arranged on two opposite sides of the second island portion 21 in the second direction (e.g., the y direction or the -y direction). In an embodiment, four second bridge portions 22 may be respectively extended to four sides of the second island portion 21. Each second bridge portion 22 may be extended to the central portion of each side of the second island portion 21.

The second island portions 21 arranged in one row in the first non-display area NDA1 may correspond to the first island portions 11 arranged in a plurality of rows in the display area DA. In an embodiment, the second island portions 21 arranged in one row in the first non-display area NDA1 may correspond to the first island portions 11 in an (i)th row and the first island portions 11 in an (i+1)th row in the display area DA (here, i is an integer greater than 0). In another embodiment, the second island portions 21 arranged in one row may correspond to n rows of the first island portions 11 (here, n is an integer greater than or equal to 3).

The third bridge portions 23 may be arranged in the second sub-non-display area SNDA2. The third bridge portions 23 connects the display area DA to the first sub-non-display area SNDA1. One end of the third bridge portion 23 may be extended to the second island portion 21, and an opposite end of the third bridge portion 23 may be extended to the first island portion 11. In an embodiment, one end of the third bridge portion 23 may be extended to the central portion of one side of the second island portion 21, and an opposite end of the third bridge portion 23 may be extended to the central portion of one side of the first island portion 11.

One of the second island portions 21 arranged in one row may be extended to one of the first island portions 11 in an (i)th row and one of the first island portions 11 in an (i+1)th row in the display area DA using the third bridge portions 23. In an embodiment, as shown in FIG. 8, one of the second island portions 21 may be extended to two first island portions 11 in a different row through two third bridge portions 23. In another embodiment, one of the second island portions 21 may be extended to three or more first island portions 11 in a different row through three or more third bridge portions 23.

The third bridge portion 23 may have a serpentine shape. In an embodiment, the shape of the third bridge portion 23 may be different from the shape of each of the first bridge portion 12 and the second bridge portion 22. The width of the third bridge portion 23 may be different from the width of the first bridge portion 12 and the width of the second bridge portion 22. The width of the third bridge portion 23 may be greater than the width of the first bridge portion 12 and less than the width of the second bridge portion 22. In the second direction (e.g., the y direction or the -y direction), the third openings CS3 and the fourth openings CS4 having different shapes may be alternately defined between the third bridge portions 23. In an embodiment, the third bridge portion 23 may include a portion rounded in a clockwise direction and a portion rounded in a counterclockwise direction.

The third island portions 31 may be arranged in the third sub-non-display area SNDA3. The third island portions 31 may correspond to the second island portions 21 in one of rows. One third island portion 31 may be extended to one second island portion 21 through the second bridge portion 22 disposed in the outermost portion. An interval portion 32 may be disposed between adjacent third island portions 31. The interval portion 32 is a kind of opening. Adjacent third island portions 31 may be spatially and physically separated from each other.

In an embodiment, an elongation of the non-display area of the display device 1 may be less than an elongation of the display area DA. An elongation of the first sub-non-display area SNDA1 of the display device 1, an elongation of the second sub-non-display area SNDA2, and an elongation of the third sub-non-display area SNDA3 may be different from each other. The elongation of the first sub-non-display area SNDA1 of the display device 1 shown in FIG. 8 may be less than an elongation of the display area DA. The elongation of the third sub-non-display area SNDA3 may be less than the elongation of the first sub-non-display area SNDA1.

In an embodiment, an elongation of the second sub-non-display area SNDA2 may be less than the elongation of the first sub-non-display area SNDA1 and less than the elongation of the display area DA. In another embodiment, an elongation of the second sub-non-display area SNDA2 may be greater than the elongation of the first sub-non-display area SNDA1 and less than the elongation of the display area DA.

As described above, because the elongation of the non-display area and the elongation of the display area DA are different from each other, electrical connection between drivers of the gate driving circuit GDC (refer to FIG. 3) that may be arranged in the second island portions 21 and the transistors arranged in the first island portions 11 may be stably maintained. In addition, a process for each operation may be stably maintained during a process of manufacturing the display device 1 having the openings (e.g., the first to fourth openings CS1, CS2, CS3, and CS4).

A width Wi1 of the first island portion 11 disposed in the display area DA may be less than a width Wi2 of the second island portion 21 disposed in the non-display area. A first distance BS1 between two adjacent first island portions 11 arranged in the display area DA may be less than a second distance BS2 between two adjacent second island portions 21 arranged in the non-display area (BS1<BS2). A ratio of the first distance BS1 to the width Wi1 of the first island portion 11 may be greater than a ratio of the second distance BS2 to the width Wi2 of the second island portion 21 (BS1/Wi1 > BS2/Wi2). A minimum value of the width Wi1 of the first island portion 11 may be tens of micrometers ($\mu$m). In an embodiment, the width Wi1 of the first island portion 11 may be tens of micrometers ($\mu$m) to hundreds of micrometers ($\mu$m). In an embodiment, the width Wi1 of the first island portion 11 may be about 10 micrometers ($\mu$m) to about 300 micrometers ($\mu$m).

Although it is shown in FIG. 8 that the first island portion 11 and the second island portion 21 are quadrangular (e.g., square), the invention is not limited thereto. The first island portion 11 and/or the second island portion 21 may be rectangular. In an alternative embodiment, the first island portion 11 and/or the second island portion 21 may have a polygon having five or more sides, or a circular shape. In an embodiment, the polygon having five or more sides may be a regular polygon.

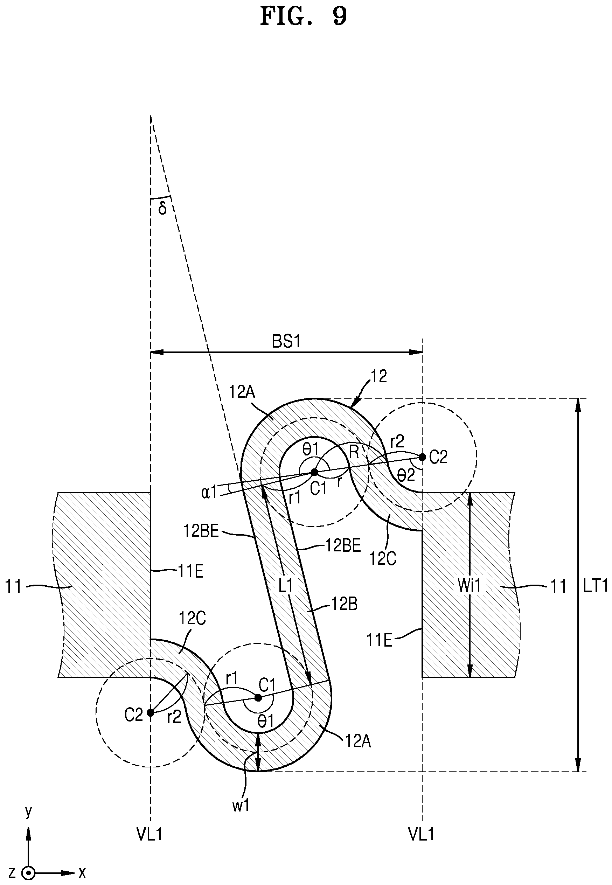

FIG. 9 is an extracted plan view of the first bridge portion 12 included in a display area DA of FIG. 8.

Referring to FIGS. 8 and 9, the first bridge portion 12 may be disposed between adjacent two first island portions 11 and may have an approximate " alphabet S" shape. The first bridge portion 12 may have a relatively constant width. In an embodiment, the first bridge portion 12 may have a first width w1.

The first bridge portion 12 may include two first rounded portions 12A and a straight portion 12B between the two first rounded portions 12A. The width of the two first rounded portions 12A and the width of the straight portion 12B may be substantially same as each other. In an embodiment, each of the two first rounded portions 12A and the straight portion 12B may have a first width w1.

Each of the first rounded portions 12A may have an arc type, e.g., an approximate circular arc shape. In an embodiment, each of the first rounded portions 12A may have a circular arc shape whose central angle (also referred to as a first central angle) is the first angle $\theta1$. The first angle $\theta1$ may be a reflex angle.

A radius of curvature r1 of the first rounded portion 12A may be a radius of a virtual circle passing through a point that is half the width of the first rounded portion 12A. The radius of curvature r1 of the first rounded portion 12A may be greater than a radius of curvature r of an inner edge of the first rounded portion 12A and less than a radius of curvature R of an outer edge of the first rounded portion 12A (r<r1<R). The radius of curvature r1 of the first rounded portion 12A may be equal to a sum of the radius of curvature r of the inner edge of the first rounded portion 12A and half the first width w1 (r1=r+(1/2)×w1). In an alternative embodiment, the radius of curvature r1 of the first rounded portion 12A may be equal to a difference between the radius of curvature R of the outer edge of the first rounded portion 12A and half the first width w1 (r1=R-(1/2)×w1). Although the above-mentioned r, r1, and R have different values, the center of the circle with the radius of the above-mentioned parameter is the same as C1. In other words, the center of a circle with the radius of curvature r1 of the first rounded portion 12A, the center of a circle with the radius of curvature r of the inner edge of the first rounded portion 12A, and the center of a circle with the radius of curvature R of the outer edge of the first rounded portion 12A may all be the same as C1.

The straight portion 12B may have an approximate straight line type. In an embodiment, the straight portion 12B may have a first width w1 and a first length L1. The first length L1 of the straight portion 12B may be greater than the first width w1. The straight portion 12B may be oblique with respect to an edge 11E of the first island portion 11. In an embodiment, an edge 12BE of the straight portion 12B is not parallel to the edge 11E of the first island portion 11 and may define a preset angle δ with respect to the edge 11E of the first island portion 11.

One end of the straight portion 12B may be connected to one of the first rounded portions 12A rounded in a clockwise direction as shown in FIG. 9, and an opposite end of the straight portion 12B may be connected to the other of the first rounded portions 12A rounded in a clockwise direction as shown in FIG. 9.

When the display device 1 (refer to FIG. 8) is transformed (e.g., stretched), a distance between adjacent two first island portions 11 may be changed while the shape of the first bridge portion 12 is transformed.

The first distance BS1 between adjacent two first island portions 11, the above-mentioned r1, and L1, as well as $\alpha 1$ may have a relationship of [Equation 1] below.

[Equation 1]

$$(BS1)min= 2r1×(2+cos\alpha 1) - L1×sin\alpha 1$$

Here, (BS1)min represents a minimum value of the first distance BS1 between adjacent two first island portions 11, r1 represents the radius of curvature r1 of the first rounded portion 12A described above, L1 represents the first length L1 of the straight portion 12B, and $\alpha 1$ represents a value obtained by subtracting 180° from the first angle θ1, which is the central angle of the first rounded portion 12A ($\alpha 1= \theta 1-180°$).

As each of the radius of curvature r1 of the first rounded portion 12A, the first length L1 of the straight portion 12B, and an angle $\alpha 1$ obtained by subtracting 180° from the first angle θ1, which is the central angle of the first rounded portion 12A increases, it is easy to disperse strain applied to the first bridge portion 12 while the display device 1 (refer to FIG. 8) is transformed (e.g., stretched). However, because a gap between adjacent two first island portions 11 is constant, and the first bridge portion 12 has the serpentine shape as described above, the above-mentioned r1, L1, and $\alpha 1$ may have a trade-off relationship. To reduce strain applied to the first bridge portion 12 during tensioning, the above-described r1 may have a value greater than 1/4 of the first distance BS1. In an embodiment, r1 may have a condition of 0.25×BS1 < r1 < 0.5×BS1. In an embodiment, $\alpha 1$ may be an acute angle. In other words, the first angle θ1, which is the central angle of the first rounded portion 12A, may be greater than 180° and less than 270°. In an embodiment, $\alpha 1$ may be greater than 0° and less than or equal to 60°(0° < $\alpha 1 \leq$ 60°).

In an embodiment, L1 may be greater than r1. In another embodiment, L1 may be equal to r1 or less than r1.

The first bridge portion 12 may further include a second rounded portion 12C unitary with the first rounded portion 12A and disposed between the first rounded portion 12A and the first island portion 11. Each second rounded portion 12C may be unitary with one end of the first rounded portion 12A.

One end of the straight portion 12B may be connected to one (e.g., the first island portion 11 shown on the right in FIG. 9) of the first island portions 11 through one of the first rounded portions 12A rounded in a clockwise direction and one of the second rounded portions 12C rounded in a counterclockwise direction as shown in FIG. 9. An opposite end of the straight portion 12B may be connected to another first island portion 11 (e.g., the first island portion 11 shown on the left in FIG. 9) through another first rounded portion 12A rounded in a clockwise direction and another second rounded portions 12C rounded in a counterclockwise direction as shown in FIG. 9.

Each of the second rounded portions 12C may have an arc type, e.g., an approximate circular arc shape. In an embodiment, each of the second rounded portions 12C may have a circular arc shape whose central angle (also referred to as a second central angle) is a second angle θ2. The second angle θ2 may be less than the first angle θ1.

A radius of curvature r2 of the second rounded portion 12C may be a radius of a virtual circle passing through a point that is half the width of the second rounded portion 12C. In an embodiment, although a center C2 of the virtual circle may be disposed on a virtual straight line VL1 passing through the edge 11E of the first island portion 11, the invention is not limited thereto. In another embodiment, the center C2 of the virtual circle may be spaced apart from the virtual straight line VL1.

A radius of curvature r2 of the second rounded portion 12C may be less than or equal to the radius of curvature r1 of the first rounded portion 12A (r2≤r1). The width of the second rounded portion 12C may be substantially same as the width of the first rounded portion 12A and the width of the straight portion 12B. In an embodiment, the width of the second rounded portion 12C may be the first width w1.

The first bridge portion 12 may be disposed in a gap between adjacent two first island portions 11 extended to each other by the first bridge portion 12, e.g., a gap having the first distance BS1. A length LT1 occupied by the first bridge portion 12 in a direction crossing the first distance BS1 may be greater than the width Wi1 of the first island portion 11. The length LT1 occupied by the first bridge portion 12 represents a straight line distance between outermost edges of the first bridge portion 12 measured in a direction crossing the first distance BS1. In an embodiment, the length LT1 occupied by the first bridge portion 12 may be greater than the width Wi1 of the first island portion 11 and less than a sum of the width Wi1 of the first island portion 11 and the first distance BS1 (Wi1 < LT1 < Wi1+BS1).

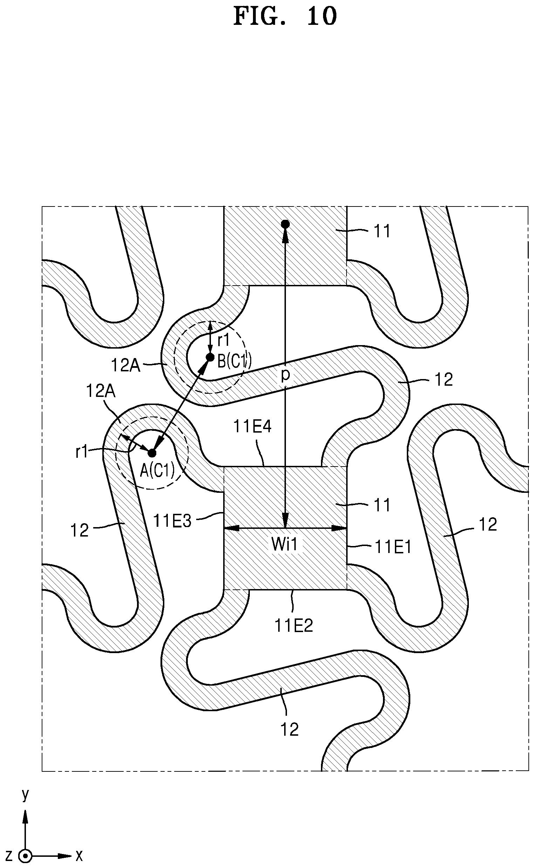

FIG. 10 is an extracted plan view of a portion disposed in the display area DA of FIG. 8.

Referring to FIG. 10, one first island portion 11 may be extended to four first bridge portions 12. One first bridge portion 12 may be disposed between adjacent two first island portions 11 to connect the adjacent two first island portions 11.

Each of the four first bridge portions 12 may be adjacent to the respective corners of the first island portion 11. One first bridge portion 12 may be extended to a first edge 11E1 of the first island portion 11 to be adjacent to a corner where the first edge 11E1 meets a second edge 11E2. Another first bridge portion 12 may be extended to the second edge 11E2 of the first island portion 11 to be adjacent to a corner where the second edge 11E2 meets a third edge 11E3. Still another first bridge portion 12 may be extended to the third edge 11E3 of the first island portion 11 to be adjacent to a corner where the third edge 11E3 meets a fourth edge 11E4. Still further another first bridge portion 12 may be extended to the fourth edge 11E4 of the first island portion 11 to be adjacent to a corner where the fourth edge 11E4 meets a first edge 11E1. Each first bridge portion 12 may have the structure described above with reference to FIG. 9.

To prevent interferences between adjacent first bridges portions 12, a straight distance between points A and B may be greater than a sum of twice the radius of curvature r1 of the first rounded portion 12A of each first bridge portion 12 and the first width w1 (refer to FIG. 9) of the first rounded portion 12A (a straight line distance between the points A and B > 2r1+w1). Here, the points A and B may be the centers (C1 described above with reference to FIG. 9) of the virtual circles corresponding to the respective first rounded portions 12A of the adjacent first bridge portions 12.

Assuming that a distance between the centers of the adjacent two first island portions 11 is p, a relationship between the radius of curvature r1 of the first rounded portion 12A of the first bridge portion 12, the first width w1 of the first rounded portion 12A, and the width Wi1 of the first island portion 11 may have a relationship of [Equation 2] below.

[Equation 2]

$$\sqrt{(r1 + 0.5w1)^2 + (Wi1 - 0.5w1 + 3r1 - p)^2} > 2r1 + w1$$

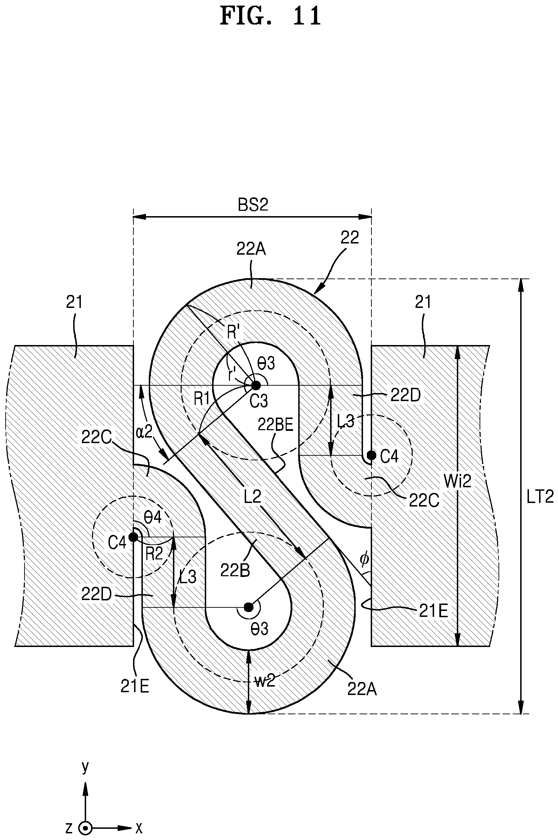

FIG. 11 is an extracted plan view of the second bridge portion 22 disposed in the non-display area of FIG. 8.

Referring to FIGS. 8 and 11, the second bridge portion 22 may be disposed between adjacent two second island portions 21 and may have an approximate" alphabet S" shape. The second bridge portion 22 may have a relatively constant width. In an embodiment, the second bridge portion 22 may have a second width w2. The second bridge portion 22 may have a shape different from the shape of the first bridge portion 12. In an embodiment, the first bridge portion 12 and the second bridge portion 22 may have a serpentine shape, e.g., an approximate" alphabet S" shape, and predetermined shapes thereof may be different from each other.

The second bridge portion 22 may include two first rounded portions 22A and a first straight portion 22B between the two first rounded portions 22A. The width of the two first rounded portions 22A and the width of the first straight portion 22B may be substantially same as each other. In an embodiment, each of the two first rounded portions 22A and the first straight portion 22B may have a second width w2. The second width w2 may be greater than the first width w1 described above with reference to FIG. 9.

Each of the first rounded portions 22A may have an approximate circular arc shape. In an embodiment, each of the first rounded portions 22A may have a circular arc shape whose central angle is a third angle θ3. The third angle θ3 may be a reflex angle. The third angle θ3 may be different from the first angle θ1 described above with reference to FIG. 9.

A radius of curvature R1 of the first rounded portion 22A may be a radius of a virtual circle passing through a point that is half the width of the first rounded portion 22A. The radius of curvature R1 of the first rounded portion 22A may be greater than a radius of curvature r' of an inner edge of the first rounded portion 22A and less than a radius of curvature R' of an outer edge of the first rounded portion 22A (r'<R1<R'). The radius of curvature R1 of the first rounded portion 22A may be equal to a sum of the radius of curvature r' of the inner edge of the first rounded portion 22A and half the second width w2 (R1=r'+(1/2) ×w2). In an alternative embodiment, the radius of curvature R1 of the first rounded portion 22A may be equal to a difference between the radius of curvature R' of the outer edge of the first rounded portion 22A and half the second width w2 (r1=R'-(1/2) ×w2). Although the above-mentioned r', R1, and R' have different values, the center of the circle with the radius of the above-mentioned parameter is the same as C3. In other words, the center of a circle with the radius of curvature R1 of the first rounded portion 22A, the center of a circle with the radius of curvature r' of the inner edge of the first rounded portion 22A, and the center of a circle with the radius of curvature R' of the outer edge of the first rounded portion 22A may all be the same as C3.

The radius of curvature R1 of the first rounded portion 22A of the second bridge portion 22 may be greater than the radius of curvature r1 of the first rounded portion 12A of the first bridge portion 12 described above with reference to FIG. 9 (R1 > r1).

The first straight portion 22B may have an approximate straight line type. In an embodiment, the first straight portion 22B may have a second width w2 and a second length L2. In an embodiment, the second length L2 of the first straight portion 22B may be greater than the second width w2. The first straight portion 22B may be oblique with respect to an edge 21E of the second island portion 21. In an embodiment, an edge 22BE of the first straight portion 22B is not parallel to the edge 21E of the second island portion 21 and may define a preset angle Φ with respect to the edge 21E of the second island portion 21. The second length L2 may be different from the first length L1 described above with reference to FIG. 9, and the above-described angle Φ may be also different from the angle δ described above with reference to FIG. 9.

One end of the first straight portion 22B may be extended to one of the first rounded portions 22A rounded in a clockwise direction as shown in FIG. 11, and an opposite end of the first straight portion 22B may be extended to the other of the first rounded portions 22A rounded in a clockwise direction as shown in FIG. 11.

When the display device 1 (refer to FIG. 8) is transformed (e.g., stretched), a distance between adjacent two second island portions 21 may be changed while the shape of the second bridge portion 22 is transformed.

In an embodiment, the second distance BS2 between adjacent two second island portions 21, the above-mentioned R1, and L2, as well as $\alpha$2 may have a relationship of [Equation 3] below.

$$[\text{Equation 3}]$$

$$(BS2)min= 2R1\times(2+\cos\alpha2) - L2\times\sin\alpha2$$

Here, (BS2)min represents a minimum value of the second distance BS2 between two adjacent second island portions 21, R1 represents the radius of curvature R1 of the first rounded portion 22A described above, L2 represents the second length L2 of the first straight portion 22B, and $\alpha$2 represents a value obtained by subtracting 180° from the third angle $\theta$3, which is the central angle of the first rounded portion 22A ($\alpha$2= $\theta$3-180°).

As each of the radius of curvature R1 of the first rounded portion 22A, the second length L2 of the first straight portion 22B, and an angle $\alpha$2 obtained by subtracting 180° from the third angle $\theta$3, which is the central angle of the first rounded portion 22A increases, it is easy to disperse strain applied to the second bridge portion 22 while the display device 1 (refer to FIG. 8) is transformed (e.g., stretched). However, because a gap between adjacent two second island portions 21 is constant, and the second bridge portion 22 has the serpentine shape as described above, the above-mentioned R1, L2, and $\alpha$2 may have a trade-off relationship. To reduce strain applied to the second bridge portion 22 during tensioning, the above-described R1 may have a value greater than 1/4 of the second distance BS2. In an embodiment, R1 may have a condition of $0.25\times BS2 < R1 < 0.5\times BS2$.

In an embodiment, $\alpha$2 may be an acute angle. In other words, the third angle $\theta$3, which is the central angle of the first rounded portion 22A, may be greater than 180° and less than 270°. In an embodiment, $\alpha$2 may be greater than 0° and equal to or less than 60°($0° < \alpha2 \leq 60°$).

In an embodiment, L2 may be greater than R1. In another embodiment, L2 may be less than or equal to R1.

The second bridge portion 22 may further include a second straight portion 22D disposed between the first rounded portion 22A and the second island portion 21, and a second rounded portion 22C. The second straight portion 22D may be disposed between the first rounded portion 22A and the second rounded portion 22C. Two opposite ends of the second straight portion 22D may be respectively unitary with the first rounded portion 22A and the second rounded portion 22C.

As shown in FIG. 11, one end of the first straight portion 22B may be extended to one (e.g., one second island portion 21 shown on the right in FIG. 11) of the second island portions 21 through one of the first rounded portions 22A rounded in a clockwise direction, one of the second straight portions 22D, and one of the second rounded portions 22C rounded in a counterclockwise direction. As shown in FIG. 11, an opposite end of the first straight portion 22B may be extended to another (e.g., another second island portion 21 shown on the left in FIG. 11) of the second island portions 21 through another of the first rounded portions 22A rounded in a clockwise direction, another of the second straight portions 22D, and another of the second rounded portions 22C rounded in a counterclockwise direction.

The second straight portion 22D may have an approximate straight line shape. The second straight portion 22D may have the second width w2 and a third length L3. The third length L3 may be less than the second length L2.

Each of the second rounded portions 22C may have an approximate circular arc shape. In an embodiment, each of the second rounded portions 22C may have a circular arc shape whose central angle is a fourth angle $\theta 4$. The fourth angle $\theta 4$ may be less than the third angle $\theta 3$. In an embodiment, the fourth angle $\theta 4$ may be an acute angle.

A radius of curvature R2 of the second rounded portion 22C may be a radius of a virtual circle passing through a point that is half the width of the second rounded portion 22C. In an embodiment, although a center C4 of the above-described virtual circle may be disposed on the second island portion 21, the invention is not limited thereto.

The radius of curvature R2 of the second rounded portion 22C may be less than or equal to the radius of curvature R1 of the first rounded portion 22A (R2≤R1). In an embodiment, FIG. 11 shows the case where R2 < R1. The width of the second rounded portion 22C may be substantially same as the width of the first rounded portion 22A, the width of the first straight portion 22B, and the width of the second straight portion 22D. In an embodiment, the width of the second rounded portion 22C may be the second width w2.

The second bridge portion 22 may be disposed in a gap between adjacent two second island portions 21 extended to each other by the second bridge portion 22, e.g., a gap having the second distance BS2. A length LT2 occupied by the second bridge portion 22 in a direction crossing the second distance BS2 may be greater than the width Wi2 of the second island portion 21. The length LT2 occupied by the second bridge portion 22 represents a straight line distance between outermost edges of the second bridge portion 22 measured in a direction crossing the second distance BS2. The length LT2 occupied by the second bridge portion 22 may be greater than the length LT1 occupied by the first bridge portion 12 described above with reference to FIG. 9. In an embodiment, the length LT2 occupied by the second bridge portion 22 may be greater than the width Wi2 of the second island portion 21 and less than a sum of the width Wi2 of the second island portion 21 and the second distance BS2 (Wi2 < LT2 < Wi2+BS2).

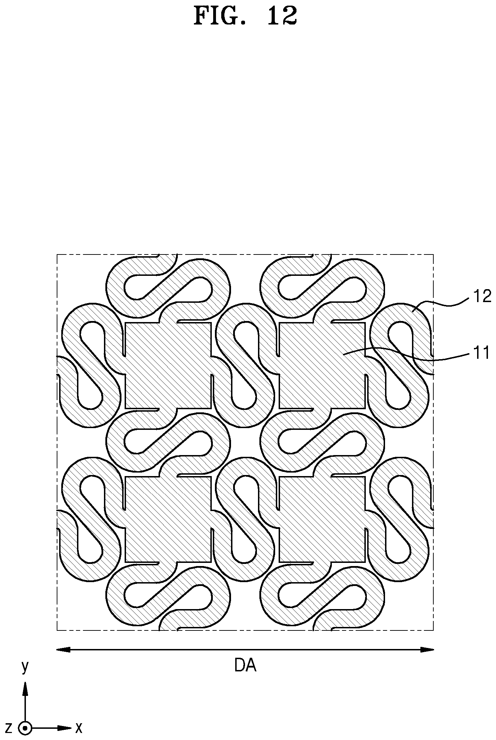

FIG. 12 is an extracted plan view of an embodiment of the display area DA of the display device.

According to the embodiment described above with reference to FIGS. 8 and 10, it is shown that each first bridge portion 12 is extended to the first island portion 11 at a position adjacent to each corner of the first island portion 11, the invention is not limited thereto. Referring to the embodiment of FIG. 12, each first bridge portion 12 may be extended to the central portion of each side of the first island portion 11. Referring to FIG. 12, the shape of the first bridge portion 12 and the shape of the second bridge portion 22 described above with reference to FIG. 11 may be substantially the same, but the first bridge portion 12 and the second bridge portion 22 described above with reference to FIG. 11 may be different from each other in their size and area.

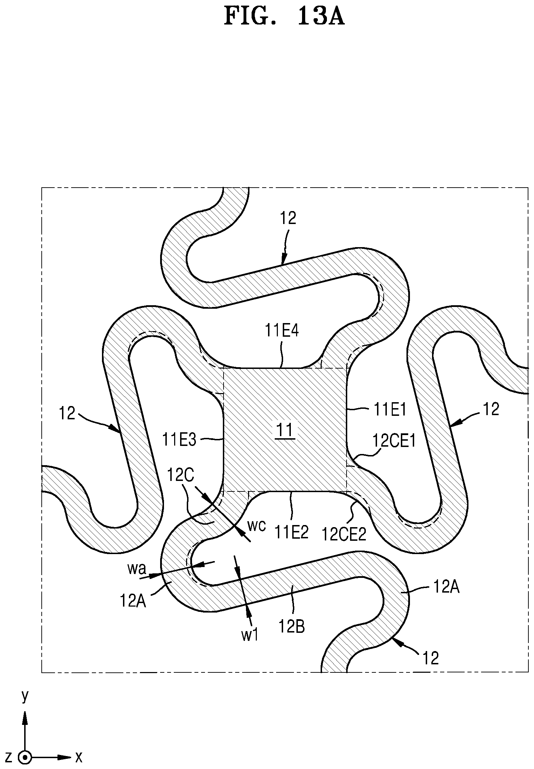

FIG. 13A is an extracted plan view of an embodiment of the display area of the display device.

According to the embodiment described above with reference to FIGS. 8 and 10, it is shown that the first bridge portion 12 has a constant width, e.g., the first width w1, the invention is not limited thereto. According to the embodiment of FIG. 13A, the first bridge portion 12 may have a locally different width. In an embodiment, the straight portion 12B of the first bridge portion 12 may have the first width w1, and a width wa of the first rounded portion 12A and/or a width wc of the second rounded portion 12C may be different from the first width w1 of the straight portion 12B. In an embodiment, the width wa of the first rounded portion 12A of the first bridge portion 12 and/or the width wc of the second rounded portion 12C may be greater than the first width w1 of the straight portion 12B.

Two opposite sides of the first bridge portion 12 extended to the first island portion 11 may be respectively and smoothly extended to the sides of the adjacent first island portions 11.

In an embodiment, one of the first bridge portions 12 is extended to the corner between the first edge 11E1 and the second edge 11E2 of the first island portion 11. The first edge 12CE1 of the second rounded portion 12C of the first bridge portion 12 may be smoothly extended to the first edge 11E1 of the first island portion 11, and the second edge 12CE2 of the second rounded portion 12C may be smoothly extended to the second edge 11E2 of the first island portion 11. When the edge of the second rounded portion 12C is smoothly extended to the edge of the first island portion 11, it may represent that an angle defined by the edge of the second rounded portion 12C and the edge of the first island portion 11 is greater than 90°.

Similarly, another of the first bridge portions 12 is extended to the corner between the second edge 11E2 and the third edge 11E3 of the first island portion 11. The first edge 12CE1 of the second rounded portion 12C of the first bridge portion 12 may be smoothly extended to the second edge 11E2 of the first island portion 11, and the second edge 12CE2 of the second rounded portion 12C may be smoothly extended to the third edge 11E3 of the first island portion 11. Still another of the first bridge portions 12 is extended to the corner between the third edge 11E3 and the fourth edge 11E4 of the first island portion 11. The first edge 12CE1 of the second rounded portion 12C of the first bridge portion 12 may be smoothly extended to the third edge 11E3 of the first island portion 11, and the second edge 12CE2 of the second rounded portion 12C may be smoothly extended to the fourth edge 11E4 of the first island portion 11. Still further another of the first bridge portions 12 is extended to the corner between the fourth edge 11E4 and the first edge 11E1 of the first island portion 11. The first edge 12CE1 of the second rounded portion 12C of the first bridge portion 12 may be smoothly extended to the fourth edge 11E4 of the first island portion 11, and the second edge 12CE2 of the second rounded portion 12C may be smoothly extended to the first edge 11E1 of the first island portion 11.

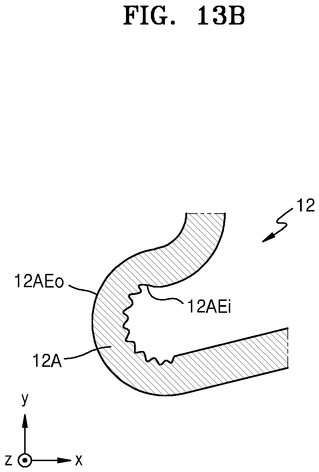

FIG. 13B is a schematic plan view of an embodiment of a first rounded portion 12A of the first bridge portion 12 of the display device.

Referring to FIG. 13B, an inner edge 12AEi of the first rounded portion 12A of the first bridge portion 12 may have zigzag irregularities rather than a smooth curve. In an embodiment, an outer edge 12AEo of the first rounded portion 12A of the first bridge portion 12 may have a smooth curve. Accordingly, the width of the first rounded portion 12A of the first bridge portion 12 may not be constant. In an embodiment, the width of the first rounded portion 12A of the first bridge portion 12 may repeatedly increase and decrease, for example. Strain concentrated on the inner edge 12AEi may be dispersed through the shape of the inner edge 12AEi of the first rounded portion 12A having the zigzag irregularities.

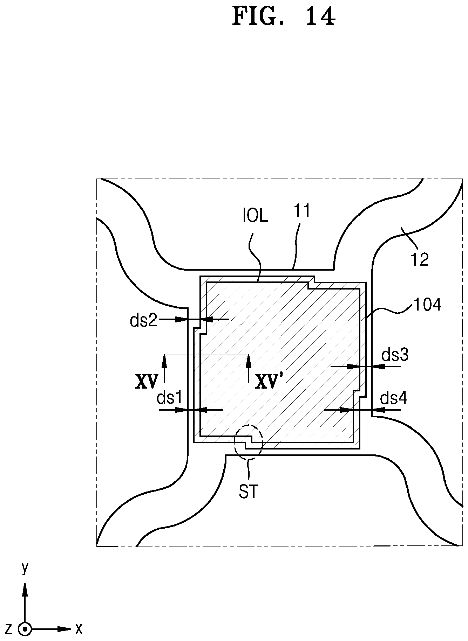

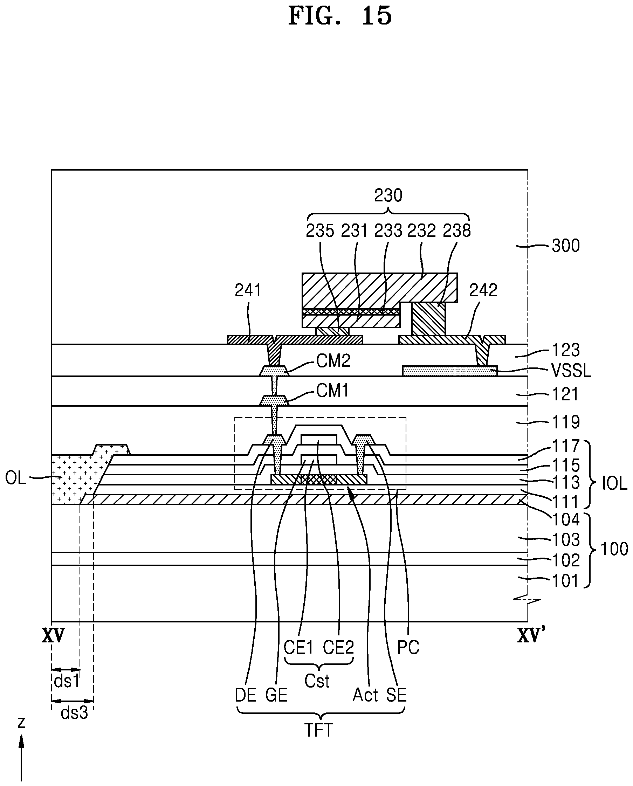

FIG. 14 is an enlarged plan view of an embodiment of a first island portion of the display device, and FIG. 15 is a cross-sectional view of the island portion 11 of FIG. 14, taken along line XV-XV' of FIG. 14.

Referring to FIGS. 14 and 15, the substrate 100 corresponding to the first island portion 11 may include a first base layer 101, a first barrier layer 102, a second base layer 103, and a second barrier layer 104. Each of the first base layer 101 and the second base layer 103 may include polymer resin such as polyethersulfone, polyarylate, polyetherimide, polyethylene naphthalate, polyethylene terephthalate, polyphenylene sulfide, polyimide, polycarbonate, cellulose tri acetate, or cellulose acetate propionate. The first barrier layer 102 and the second barrier layer 104 may each include an inorganic insulating material such as silicon oxide, silicon nitride, or silicon oxynitride.

The size or area of an inorganic insulating layer, e.g., the second barrier layer 104 disposed on the uppermost layer of the substrate 100 may be less than the size or area of the first island portion 11 shown in FIG. 14. Referring to FIG. 15, the size or area of an inorganic insulating layer, e.g., the second barrier layer 104 disposed on the uppermost layer of the substrate 100 may be less than the size or area of the first base layer 101, the first barrier layer 102, and/or the second base layer 103 of the substrate 100 corresponding to the first island portion 11.

As shown in FIG. 14, the edge of the second barrier layer 104 may be apart inward from the edge of the first island portion 11 by a first separation distance ds1. In other words, as shown in FIG. 15, the edge of the second barrier layer 104 may be spaced apart from the edges of the first base layer 101, the first barrier layer 102, and/or the second base layer 103 by the first separation distance ds1.

Referring to FIG. 14, near the corner of the first island portion 11 where the first bridge portion 12 is connected, the edge of the second barrier layer 104 may be apart inward from the edge of the first island portion 11 by a second separation distance ds2. The second separation distance ds2 may have a value greater than that of the first separation distance ds1.

Due to a difference between the first separation distance ds1 and the second separation distance ds2, a stepped portion ST may be disposed in a plan view as shown in FIG. 14. The stepped portion ST may be disposed between the first bridge portion 12 and the adjacent another first bridge portion 12.

Referring to FIG. 15, the buffer layer 111 may be disposed on the substrate 100, and the pixel driving circuit PC may be disposed on the buffer layer 111. The buffer layer 111 may include an inorganic insulating material such as silicon oxide, silicon nitride, or silicon oxynitride.

The thin-film transistor TFT may include a semiconductor layer Act, a gate electrode GE, a source electrode SE, and a drain electrode DE. The thin-film transistor TFT may correspond to the first transistor T1 in FIG. 6A, or correspond to the sixth transistor T6 or the seventh transistor T7 in FIGS. 6B and 6C. Although FIG. 15 shows a top-gate type thin-film transistor in which the gate electrode GE is disposed over the semiconductor layer Act with a gate insulating layer 113 therebetween, a thin-film transistor TFT may be a bottom-gate type thin-film transistor in another embodiment.

The semiconductor layer Act may include polycrystalline silicon. In an alternative embodiment, the semiconductor layer Act may include amorphous silicon, an oxide semiconductor, or an organic semiconductor. The gate electrode GE may include a low-resistance metal material. The gate electrode GE may include a conductive material including molybdenum (Mo), aluminum (Al), copper (Cu), or titanium (Ti) and have a single-layered structure or a multi-layered structure including the above materials.

The gate insulating layer 113 between the semiconductor layer Act and the gate electrode GE may include an inorganic insulating material such as silicon oxide, silicon nitride, silicon oxynitride, aluminum oxide, or titanium oxide. The gate insulating layer 113 may include a single layer or a multi-layer including the above materials.

The source electrode SE and the drain electrode DE may be disposed in the same layer, e.g., on a second inter-insulating layer 117, and may include the same material as each other. The source electrode SE and the drain electrode DE may each include a material having relatively high conductivity. The source electrode SE and the drain electrode DE may each include a conductive material including molybdenum (Mo), aluminum (Al), copper (Cu), or titanium (Ti) and include a single layer or a multi-layer including the above materials. In an embodiment, the source electrode SE and the drain electrode DE may be formed as a multi-layered structure of a titanium layer, an aluminum layer, and a titanium layer (Ti/Al/Ti). The second inter-insulating layer 117 may include an inorganic insulating material such as silicon oxide, silicon nitride, silicon oxynitride, aluminum oxide, or titanium oxide, and include a single layer or a multi-layer including the above materials.

The storage capacitor Cst may include the first electrode CE1 and the second electrode CE2 overlapping each other with a first inter-insulating layer 115 therebetween. The storage capacitor Cst may overlap the thin-film transistor TFT. With regard to this, it is shown in FIG. 15 that the gate electrode GE of the thin-film transistor TFT serves as the first electrode CE1 of the storage capacitor Cst. In another embodiment, the storage capacitor Cst may not overlap the thin-film transistor TFT. The storage capacitor Cst may be covered by the second inter-insulating layer 117. The second electrode CE2 of the storage capacitor Cst may include a conductive material including molybdenum (Mo), aluminum (Al), copper (Cu), or titanium (Ti) and have a single-layered structure or a multi-layered structure including the above materials. The first inter-insulating layer 115 may be disposed between the gate insulating layer 113 and the second inter-insulating layer 117. The first inter-insulating layer 115 may include an inorganic insulating material such as silicon oxide, silicon nitride, silicon oxynitride, aluminum oxide, or titanium oxide, and include a single layer or a multi-layer including the above materials.

The size or area of an inorganic insulating material layer IOL corresponding to the first island portion 11 may be less than the size or area of the first island portion 11 as shown in FIG. 14. Referring to FIG. 15, the size or area of the inorganic insulating material layer IOL disposed on the substrate 100 may be less than the size or area of the first base layer 101, the first barrier layer 102, and/or the second base layer 103 of the substrate 100. The inorganic insulating material layer IOL on the substrate 100 may include the buffer layer 111, the gate insulating layer 113, the first inter-insulating layer 115, and the second inter-insulating layer 117, for example.

As shown in FIG. 14, the edge of the inorganic insulating material layer IOL may be apart inward from the edge of the first island portion 11 by a third separation distance ds3. In other words, as shown in FIG. 15, the edge of inorganic insulating material layer IOL may be spaced apart from the edges of the first base layer 101, the first barrier layer 102, and/or the second base layer 103 of the substrate 100 by the third separation distance ds3. The edges of the first base layer 101, the first barrier layer 102, and/or the second base layer 103 of the substrate 100 corresponding to the first island portion 11 may correspond to the edge of the first island portion 11.

Referring to FIG. 14, near the corner of the first island portion 11 to which the first bridge portion 12 is extended, the edge of the inorganic insulating material layer IOL may be apart inward from the edge of the first island portion 11 by a fourth separation distance ds4. The fourth separation distance ds4 may have a value greater than that of the third separation distance ds3.

The third separation distance ds3 may be greater than the first separation distance ds1. The fourth separation distance ds4 may be greater than the second separation distance ds2. In other words, as shown in FIG. 15, the edge of the inorganic insulating material layer IOL does not pass through the edge of the second base layer 103 and may be disposed on the upper surface of the second base layer 103.

The edge of the inorganic insulating material layer IOL and the edge of the second barrier layer 104 may overlap an organic material layer OL. The organic material layer OL defines an opening corresponding to the central portion of the first island portion 11 and may have a kind of frame shape extending along the edge of the first island portion 11.

The organic material layer OL may cover the edge of the inorganic insulating material layer IOL having a step difference with respect to the upper surface of the second barrier layer 104, and the edge of the second barrier layer 104. In an embodiment, the organic material layer OL may overlap the step difference. The organic material layer OL may include an organic insulating material such as polyimide.

A first organic insulating layer 119 may be disposed on the second inter-insulating layer 117, and a second organic insulating layer 121 may be disposed on the first organic insulating layer 119. The first organic insulating layer 119 and the second organic insulating layer 121 may each include an organic insulating material such as polyimide.

The second voltage line VSSL may be disposed on the second organic insulating layer 121, and a third organic insulating layer 123 may be disposed on the second organic insulating layer 121. The third organic insulating layer 123 may include an organic insulating material such as polyimide. The second voltage line VSSL may include a conductive material including molybdenum (Mo), aluminum (Al), copper (Cu), or titanium (Ti) and include a single layer or a multi-layer including the above materials.

A first electrode pad 241 and a second electrode pad 242 may be disposed on the third organic insulating layer 123. The first electrode pad 241 may be electrically connected to the thin-film transistor TFT through a first connection piece CM1 and a second connection piece CM2. The first connection piece CM1 is between the first organic insulating layer 119 and the second organic insulating layer 121, and the second connection piece CM2 is between the second organic insulating layer 121 and the third organic insulating layer 123. The inorganic light-emitting diode 230 on the first electrode pad 241 and the second electrode pad 242 is the same as the inorganic light-emitting diode 230 described above with reference to FIG. 7B. A light-emitting diode, e.g., the inorganic light-emitting diode 230 may be protected by the encapsulation layer 300. The encapsulation layer 300 may include an inorganic encapsulation layer and/or an organic encapsulation layer, or an organic material such as resin. Although it is shown in FIG. 15 that the light-emitting diode 230 is the inorganic light-emitting diode described with reference to FIG. 7B, the light-emitting diode may be the organic light-emitting diode 220 described with reference to FIG. 7A.

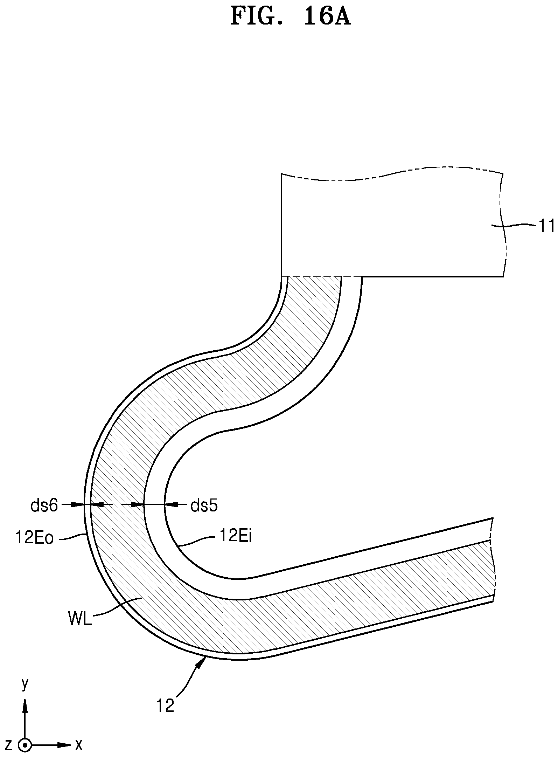

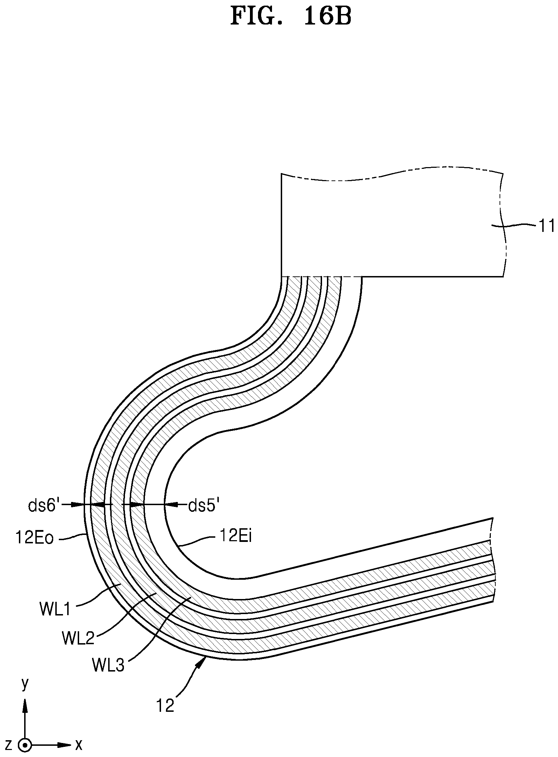

FIGS. 16A and 16B are plan views of embodiments of a configuration of a wiring on the first bridge portion 12 of the display device, respectively.

Referring to FIG. 16A, the wiring WL is disposed on the first bridge portion 12 and may be disposed biased toward an outer edge 12Eo of the first bridge portion 12. In an embodiment, a fifth separation distance ds5 between an inner edge 12Ei of the first bridge portion 12 and the wiring WL may be greater than a sixth separation distance ds6 between the outer edge 12Eo of the first bridge portion 12 and the wiring WL.

Referring to FIG. 16B, a plurality of wirings, e.g., first to third wirings WL1, WL2, and WL3 are disposed on the first bridge 12 and may be disposed biased toward the outer edge 12Eo of the first bridge portion 12. In an embodiment, a fifth separation distance ds5' between the third wiring WL3 closest to the inner edge 12Ei of the first bridge portion 12 and the inner edge 12Ei of the first bridge portion 12 may be greater than a sixth separation distance ds6' between the first wiring WL1 closest to the outer edge 12Eo of the first bridge portion 12 and the outer edge 12Eo of the first bridge portion 12.

The display device in an embodiment may have one of the structures shown in FIGS. 16A and 16B. The display device in another embodiment may have all of the structures shown in FIGS. 16A and 16B. In an embodiment, the wiring WL shown in FIG. 16A may be disposed between the second organic insulating layer 121 and the third organic insulating layer 123 described with reference to FIG. 15. In addition, the first to third wirings WL1, WL2, and WL3 shown in FIG. 16B may be disposed between the first organic insulating layer 119 and the second organic insulating layer 121 described with reference to FIG. 15. In other words, the wiring WL of FIG. 16A and the first to third wirings WL1, WL2, and WL3 of FIG. 16B are disposed in different layers and may be electrically connected to the same pixel driving circuit PC (refer to FIG. 15). In an embodiment, the wiring WL of FIG. 16A may be the second voltage line VSSL (refer to FIG. 15), and each of the first to third wirings WL1, WL2, and WL3 may be a data line which provides data signals to the first island portion 11, a scan line, or the like.

The display device in the embodiments may be used in various electronic apparatuses capable of displaying images. Here, the electronic apparatuses denote apparatuses that use electricity and may display preset images.

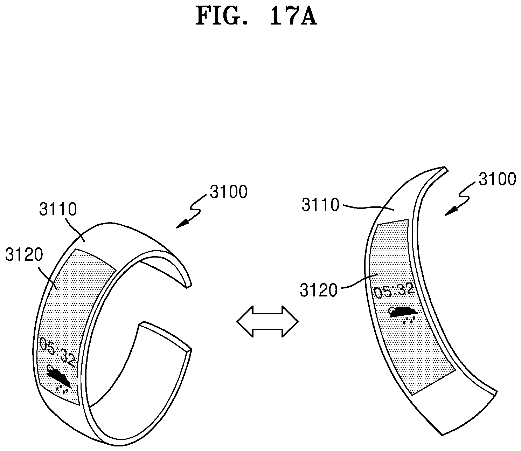

FIGS. 17A to 17G are perspective views of embodiments of an electronic apparatus including the display device, respectively.

Referring to FIG. 17A, the display device in an embodiment may be utilized in a wearable electronic apparatus 3100 that may be worn on a portion of a user's body. The wearable electronic apparatus 3100 may include a body portion 3110 and a display 3120 provided on the body portion 3110. The display device in embodiments may be used as the display 3120 of the wearable electronic apparatus 3100. As shown in FIG. 17A, the wearable electronic apparatus 3100 may be transformed. In an embodiment, the wearable electronic apparatus 3100 may be used as a smartwatch or a smartphone depending on a user's selection.

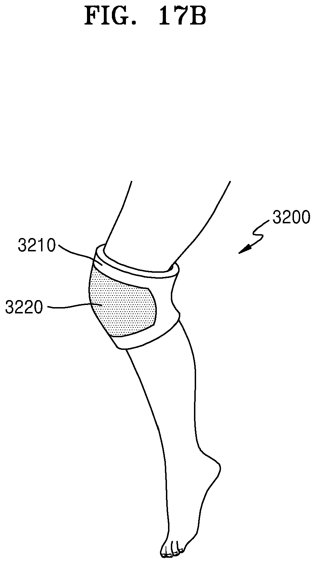

FIG. 17B shows a medical electronic apparatus 3200. In an embodiment, the medical electronic apparatus 3200 may include a body portion 3210 and an emission portion 3220. The display device in embodiments may be used as the emission portion 3220 of the medical electronic apparatus 3200. The emission portion 3220 may emit light in a preset wavelength band (e.g., an infrared ray, a visible ray, or the like) to a patient's body. In an embodiment, the body portion 3210 may include a stretchable fiber material and may have a structure that may be worn on the body of the user who uses the emission portion 3220.

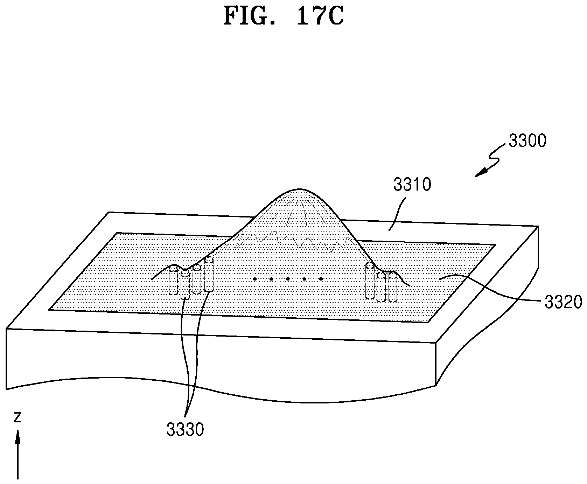

FIG. 17C shows an educational electronic device 3300. In an embodiment, the educational electronic device 3300 may include a display 3320 provided inside a frame 3310. The display 3320 may use the display device in embodiments. Images such as sea with waves, a mountain covered with snow, or a volcano with flowing lava may be provided through the display 3320, and in this case, the display 3320 may extend in the height direction (e.g., a z direction) to reflect the height of waves, mountains, or volcanoes. In an embodiment, a portion of the display 3320 may show the movements of lava three dimensionally by sequentially changing its height in a direction in which the lava flows. The educational electronic device (hereinafter, also referred to as an educational electronic apparatus) 3300 may include a plurality of pins 3330 (or stroke portions) disposed on the backside of the display 3320 such that the display 3320 extends in a height direction. As the pins 3330 move in the third direction (e.g., a z direction or a -z direction), the image displayed on the display 3320 may be implemented to have a three-dimensional height. Although FIG. 17C describes the educational electronic apparatus 3300, the purpose of the electronic apparatus is not limited as long as the electronic apparatus provides preset image information.

Although the electronic apparatuses shown in FIGS. 17A to 17C are described as electronic apparatuses whose shapes are variable, the invention is not limited thereto. As in embodiments described below, the display device in embodiments may be used in an electronic apparatus in which a portion (e.g., a screen) capable of displaying images is fixed.

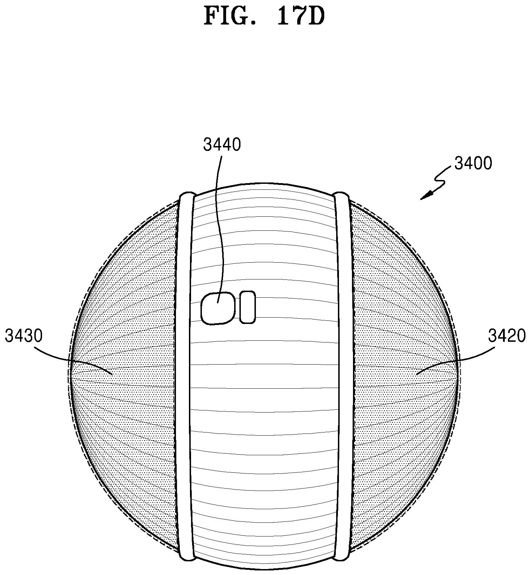

FIG. 17D shows a robot 3400 as an electronic apparatus. The robot 3400 may move or recognize an object by a camera portion 3440 and display preset images to a user through displays 3420 and 3430. In an embodiment, because the display devices in an embodiment may be stretched in various directions as described above, the display devices may be assembled to a body frame having a hemispherical shape, and thus, the robot 3400 may include the displays 3420 and 3430 having a hemispherical shape.

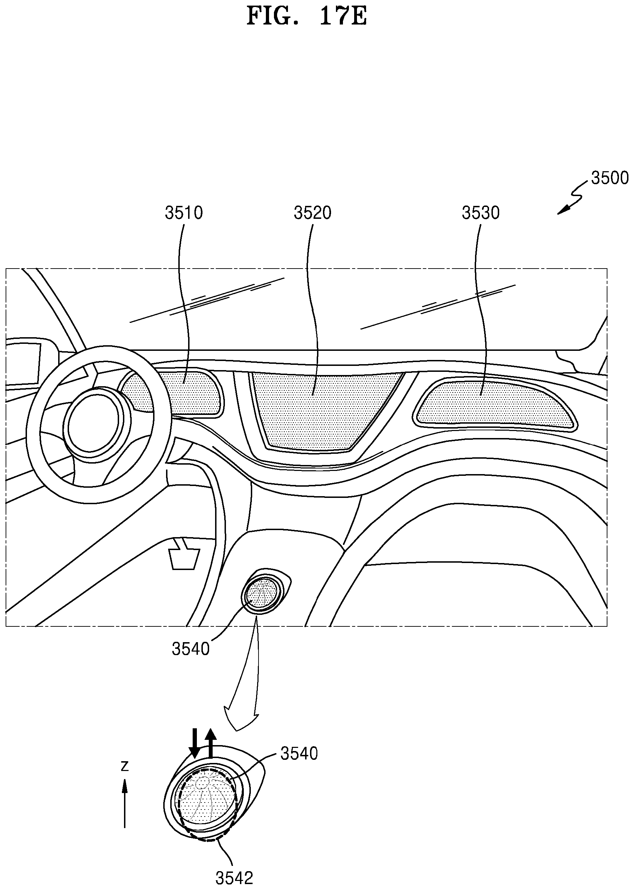

FIG. 17E shows a vehicle display device 3500 as another electronic apparatus. The vehicle display device 3500 may include a cluster 3510, a center information display ("CID") 3520, and/or a passenger display 3530. Because the display device in an embodiment may be stretched in various directions, the display device may be used as the cluster 3510, the CID 3520, and/or the passenger display (hereinafter, also referred to as a co-driver display) 3530 regardless of the shape of an internal frame of the vehicle.

Although it is shown in FIG. 17E that the cluster 3510, the CID 3520, and/or the co-driver display 3530 are separated from each other, the invention is not limited thereto. In another embodiment, two or more of the cluster 3510, the CID 3520, and/or the co-driver display 3530 may be integrally connected.

In an embodiment, the vehicle display device 3500 may further include a button 3540 that may display preset images. Referring to an enlarged view of the button 3540 in FIG. 17E, the button 3540 having a hemispherical shape may include an object 3542 that provides the feeling of using the button while moving in the z direction or -z direction, and a display device disposed on the object 3542. In an embodiment, in the case where the object 3542 has a surface rounded three-dimensionally, the display device may also have a surface rounded three-dimensionally.

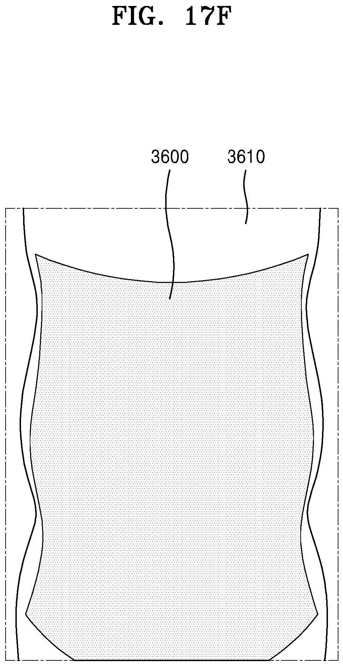

FIG. 17F shows that the electronic apparatus in an embodiment is an electronic apparatus 3600 for advertising or exhibition. In an embodiment, the electronic apparatus 3600 for advertising or exhibition may be installed on a structure 3610 such as a wall or pillar. In the case where the structure 3610 includes an uneven surface as shown in FIG. 17F, the electronic apparatus 3600 for advertising or exhibition may be also disposed along the uneven surface of the structure 3610. In an embodiment, the electronic apparatus 3600 for advertising or exhibition may be installed on the structure 3610 using a heat shrink film or the like.

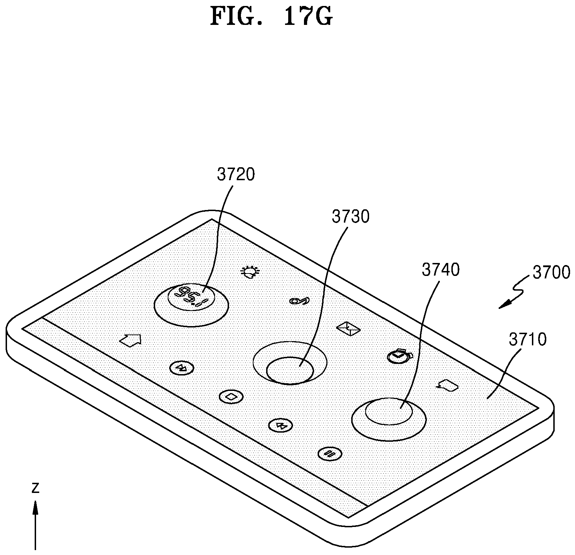

FIG. 17G shows that the electronic apparatus in an embodiment is a controller 3700. The controller 3700 may include an image type button. In an embodiment, the controller 3700 may include first to third button regions 3720, 3730, and 3740 in which a partial region of a display 3710 protrudes in a z direction or -z direction (or collapses in the z direction). In an embodiment, the first and third button regions 3720 and 3740 may protrude in the z direction, and the second button region 3730 may protrude in the -z direction (or collapse in the z direction).

In an embodiment, the display device in which a damage due to concentration of stress may be prevented and which may be stretched in various directions may be provided. In an embodiment, electrical connection between elements constituting the display device may be stably maintained.

However, this above effects are an example, and the invention is not limited by those effects.

It should be understood that embodiments described herein should be considered in a descriptive sense only and not for purposes of limitation. Descriptions of features or advantages within each embodiment should typically be considered as available for other similar features or advantages in other embodiments. While embodiments have been described with reference to the drawing figures, it will be understood by those of ordinary skill in the art that various changes in form and details may be made therein without departing from the spirit and scope as defined by the following claims.

**Claims**

1. A display device (1) including a display area (DA) and a non-display area (NDA) outside the display area (DA), the display device (1) comprising:

   first island portions (11) arranged in the display area (DA), the first island portions (11) being spaced apart from each other in row and column directions;
   first bridge portions (12) respectively connecting two first island portions (11) among the first island portions (11);
   second island portions (21) arranged in the non-display area (NDA), the second island portions (21) being spaced apart from each other; and
   second bridge portions (22) respectively connecting two second island portions (21) among the second island portions (21),
   wherein a first width (Wi1) of each of the first island portions (11) is less than a second width (Wi2) of each of the second island portions (21), and
   one of the second island portions (21) corresponds to a first island portion (11) in an (i)th row among the first island portions (11) and a first island portion (11) in an (i+1)th row among the first island portions (11), where i is a positive integer.

2. The display device (1) of claim 1, wherein each of the second bridge portions (22) has a shape different from a shape of each of the first bridge portions (12).

3. A display device (1) including a display area (DA) and a non-display area (NDA) outside the display area (DA), the display device (1) comprising:

   first island portions (11) arranged in the display area (DA), the first island portions (11) being spaced apart from each other in row and column directions;

first bridge portions (12) respectively connecting two first island portions (11) among the first island portions (11);

second island portions (21) arranged in the non-display area (NDA), the second island portions (21) being spaced apart from each other; and

second bridge portions (22) respectively connecting two second island portions (21) among the second island portions (21),

wherein a shape of each of the second bridge portions (22) is different from a shape of each of the first bridge portions (12).

4. The display device (1) of claim 3, wherein a first width (Wi1) of each of the first island portions (11) is less than a second width (Wi2) of each of the second island portions (21), and one of the second island portions (21) corresponds to a first island portion (11) in an (i)th row among the first island portions (11) and a first island portion (11) in an (i+1)th row among the first island portions (11), where i is a positive integer.

5. The display device (1) of claim 1 or 4, wherein the one of the second island portions (21) is connected to the first island portion (11) in the (i)th row and the first island portion (11) in the (i+1)th row through third bridge portions (23).

6. The display device (1) of at least one of claims 1 to 5, wherein an elongation of the non-display area (NDA) is less than an elongation of the display area (DA).

7. The display device (1) of claim 5 or of claims 5 and 6, wherein the non-display area (NDA) comprises:

a first sub-non-display area (SNDA1) in which the second island portions (21) and the second bridge portions (22) are arranged; and

a second sub-non-display area (SNDA2) disposed between the first sub-non-display area (SNDA1) and the display area (DA), wherein the third bridge portions (23) are arranged in the second sub-non-display area (SNDA2), and

wherein an elongation of the first sub-non-display area (SNDA1) is different from an elongation of the second sub-non-display area (SNDA2).

8. The display device (1) of claim 7, wherein an elongation of the second sub-non-display area (SNDA2) is less than an elongation of the first sub-non-display area (SNDA1) and an elongation of the display area (DA).

9. The display device (1) of claim 7, wherein an elongation of the second sub-non-display area (SNDA2) is greater than an elongation of the first sub-non-display area (SNDA1) and less than an elongation of the display area (DA).

10. The display device (1) of at least one of claims 1 to 9, wherein each of the first bridge portions (12) is arranged between two adjacent first island portions (11) immediately next to each other, each of the second bridge portions (22) is arranged between two adjacent second island portions (21) immediately next to each other, and a first distance (BS1) between the two adjacent first island portions (11) is less than a second distance (BS2) between the two adjacent second island portions (21).

11. The display device (1) of claim 10, wherein a ratio of the first distance (BS1) to the first width (Wi1) of the first island portion (11) is greater than a ratio of the second distance (BS2) to the second width (Wi2) of the second island portion (21).

12. The display device (1) of at least one of claims 1 to 11, wherein a width of each of the first bridge portions (12) is less than a width of each of the second bridge portions (22).

13. The display device (1) of at least one of claims 1 to 12, wherein each of the first bridge portions (12) and the second bridge portions (22) has a serpentine shape.

14. The display device (1) of claim 13, wherein each of the first bridge portions (12) comprises:

two first rounded portions (12A); and
a straight portion (12B) between the two first rounded portions (12A).

15. The display device (1) of claim 14, wherein the straight portion (12B) of each of the first bridge portions (12) is oblique with respect to one side of an adjacent first island portion (11) which is immediately next to the straight portion (12B).

16. The display device (1) of claim 14 or 15, wherein each of the two first rounded portions (12A) has a circular arc shape with a first central angle, and the first central angle is a reflex angle.

17. The display device (1) of at least one of claims 14 to 16, wherein each of the first bridge portions (12) further comprises two second rounded portions (12C) respectively connected to the two first rounded portions (12A).

18. The display device (1) of claim 17, wherein each of the two second rounded portions (12C) has a circular arc shape with a second central angle, and the second central angle is less than the first central angle.

19. The display device (1) of at least one of claims 14 to 18, wherein each of the two first rounded portions (12A) of each of the first bridge portions (12) includes an inner edge (12Ei) and an outer edge, and the inner edge (12Ei) has irregularities.

20. The display device (1) of at least one of claims 1 to 19, wherein each of the second bridge portions (22) comprises:

two first rounded portions (22A);
a first straight portion (22B) between the two first rounded portions (22A);
two second straight portions (22D) respectively connected to the two first rounded portions (22A); and
two second rounded portions (22C) respectively connected to the two second straight portions (22D).

21. The display device (1) of claim 20, wherein a length of the first straight portion (22B) of each of the second bridge portions (22) is greater than a length of a second straight portion (22D) of the two second straight portions (22D).

22. The display device (1) of claim 20 or 21, wherein each of the two first rounded portions (22A) of each of the second bridge portions (22) has a circular arc shape with a first central angle,

wherein each of the two second rounded portions (22C) of each of the second bridge portions (22) has a circular arc shape with a second central angle, and
wherein the first central angle is greater than the second central angle.

23. The display device (1) of at least one of claims 1 to 22, wherein each of the first island portions (11) includes an inorganic insulating layer including an inorganic insulating material, and an edge of the inorganic insulating layer is spaced apart from an edge (11E1-4) of each of the first island portions (11).

24. The display device (1) of claim 23, further comprising a substrate (100) under the inorganic insulating layer,

wherein the substrate (100) includes a base layer (101) and a barrier layer (102), the base layer (101) includes polymer resin, and the barrier layer (102) is disposed on the base layer (101) and includes an inorganic insulating material, and
wherein an edge of the barrier layer (102) is spaced apart from an edge (11E1-4) of each of the first island portions (11).

25. The display device (1) of claim 24, wherein the inorganic insulating layer and the barrier layer (102) of the substate form a step difference.

26. The display device (1) of claim 25, further comprising an organic material layer covering the edge of the barrier layer (102) and the edge of the inorganic insulating layer and overlapping the step difference.

27. The display device (1) of at least one of claims 1 to 26, wherein each of the first island portions (11) comprises:

a transistor (TFT); and
a light-emitting diode (LED) electrically connected to the transistor (TFT),
wherein a portion of a wiring (WL) electrically connected to the transistor (TFT) of one of the first island portions (11) is disposed on a first bridge portion (12) connected to one of the first island portions (11), and
a first separation distance (ds5) between an inner edge (12Ei) of the first bridge portion (12) and the wiring (WL) is greater than a second separation distance (ds6) between an outer edge (12Eo) of the first bridge portion (12) and

the wiring (WL).

# FIG. 1

FIG. 2A

# FIG. 2B

# FIG. 2C

# FIG. 2D

# FIG. 2E

# FIG. 3

# FIG. 4A

EP 4 510 814 A1

# FIG. 4B

EP 4 510 814 A1

FIG. 4C

# FIG. 5

# FIG. 6A

# FIG. 6B

# FIG. 6C

# FIG. 7A

# FIG. 7B

# FIG. 8

# FIG. 9

# FIG. 10

# FIG. 11

# FIG. 12

# FIG. 13A

# FIG. 13B

FIG. 14

# FIG. 15

# FIG. 16A

# FIG. 16B

11

ds6'    ds5'

12Eo    12Ei

WL1

WL2

WL3

12

y

z    x

# FIG. 17A

# FIG. 17B

# FIG. 17C

FIG. 17D

# FIG. 17E

# FIG. 17F

# FIG. 17G

Europäisches
Patentamt

European
Patent Office

Office européen
des brevets

**EUROPEAN SEARCH REPORT**

Application Number

EP 24 19 4728

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 112 258 994 A (SHANGHAI TIANMA MICROELECTRONICS CO LTD) 22 January 2021 (2021-01-22) | 1-15 | INV. H10K77/10 |
| Y | * paragraphs [0039] - [0056]; figures 4-12 * | 16-19, 23-27 | |
| A | | 20-22 | |
| | - - - - - | | |
| X | CN 113 436 535 A (WUHAN CHINA STAR OPTOELECTRONICS SEMICONDUCTOR DISPLAY TECH CO LTD) 24 September 2021 (2021-09-24) * figure 6 * | 1-8, 10-14,17 | |
| X,P | -& US 2024/031463 A1 (YIN BINGKUN [CN]) 25 January 2024 (2024-01-25) * paragraphs [0046] - [0062], [0081] - [0087]; figures 1,6 * | 1-8, 10-14,17 | |
| | - - - - - | | |
| Y | US 2023/019276 A1 (SANO TAKUMI [JP]) 19 January 2023 (2023-01-19) * paragraphs [0039] - [0063], [0081] - [0109]; figures 2-4,8-12 * | 16-19 | |
| | - - - - - | | TECHNICAL FIELDS SEARCHED (IPC) |
| Y | US 2018/046221 A1 (CHOI JINWOO [KR] ET AL) 15 February 2018 (2018-02-15) * paragraphs [0021] - [0074]; figures 1-5 * | 23-27 | H10K |
| | - - - - - | | |

The present search report has been drawn up for all claims

| Place of search | Date of completion of the search | Examiner |
|---|---|---|
| The Hague | 17 December 2024 | Bakos, Tamás |

EPO FORM 1503 03.82 (P04C01)

**ANNEX TO THE EUROPEAN SEARCH REPORT
ON EUROPEAN PATENT APPLICATION NO.**

EP 24 19 4728

This annex lists the patent family members relating to the patent documents cited in the above-mentioned European search report.
The members are as contained in the European Patent Office EDP file on
The European Patent Office is in no way liable for these particulars which are merely given for the purpose of information.

17-12-2024

| Patent document cited in search report | | Publication date | Patent family member(s) | | Publication date |
|---|---|---|---|---|---|
| CN 112258994 | A | 22-01-2021 | NONE | | |
| CN 113436535 | A | 24-09-2021 | CN | 113436535 A | 24-09-2021 |
| | | | US | 2024031463 A1 | 25-01-2024 |
| | | | WO | 2023272839 A1 | 05-01-2023 |
| US 2024031463 | A1 | 25-01-2024 | CN | 113436535 A | 24-09-2021 |
| | | | US | 2024031463 A1 | 25-01-2024 |
| | | | WO | 2023272839 A1 | 05-01-2023 |
| US 2023019276 | A1 | 19-01-2023 | JP | 7548715 B2 | 10-09-2024 |
| | | | JP | 2021150584 A | 27-09-2021 |
| | | | US | 2023019276 A1 | 19-01-2023 |
| | | | WO | 2021192506 A1 | 30-09-2021 |
| US 2018046221 | A1 | 15-02-2018 | CN | 107731866 A | 23-02-2018 |
| | | | KR | 101810050 B1 | 19-12-2017 |
| | | | US | 2018046221 A1 | 15-02-2018 |
| | | | US | 2019258297 A1 | 22-08-2019 |

EPO FORM P0459

For more details about this annex : see Official Journal of the European Patent Office, No. 12/82